# EUROPEAN PATENT APPLICATION

(11) **EP 4 167 700 A1**
(43) Date of publication of application: **19.04.2023**
(21) Application number: 22189088.2
(22) Date of filing: 05.08.2022
(51) Int. Cl.: H10B 12/00

(54) **SEMICONDUCTOR MEMORY DEVICE AND METHOD OF FABRICATING THE SAME**

(30) Priority: 13.10.2021 KR 20210135961
(71) Applicant: Samsung Electronics Co., Ltd., Gyeonggi-do, 16677 (KR)
(72) Inventor: KIM, Hyo-Sub, 16677 Suwon-si (KR); AHN, Junhyeok, 16677 Suwon-si (KR); LEE, Myeong-Dong, 16677 Suwon-si (KR); KIM, Hui-Jung, 16677 Suwon-si (KR); LEE, Kiseok, 16677 Suwon-si (KR); LEE, Jihun, 16677 Suwon-si (KR); HWANG, Yoosang, 16677 Suwon-si (KR)
(74) Representative: Marks & Clerk LLP

(57) **Abstract**

A semiconductor memory device and a method of fabricating a semiconductor memory device, the device including a first impurity region in a substrate; a first bit line that crosses over the substrate and is connected to the first impurity region; a bit-line contact between the first bit line and the first impurity region; and a contact ohmic layer between the bit-line contact and the first impurity region, wherein a width of a bottom surface of the bit-line contact is greater than a width of a bottom surface of the contact ohmic layer.

## Description

### BACKGROUND

### 1. Field

Embodiments relate to a semiconductor memory device and a method of fabricating the same.

### 2. Description of the Related Art

Semiconductor devices are beneficial in the electronic industry because of their small size, multi-functionality, and low fabrication cost. However, the semiconductor devices are being highly integrated with the remarkable development of the electronic industry. Line widths of patterns of semiconductor devices are being reduced for high integration thereof.

### SUMMARY

The disclosure includes providing a semiconductor memory device including a first impurity region in a substrate; a first bit line that crosses over the substrate and is connected to the first impurity region; a bit-line contact between the first bit line and the first impurity region; and a contact ohmic layer between the bit-line contact and the first impurity region, wherein a width of a bottom surface of the bit-line contact is greater than a width of a bottom surface of the contact ohmic layer.

The disclosure includes providing a semiconductor memory device including a first impurity region in a substrate; a first bit line that crosses over the substrate and is connected to the first impurity region; a bit-line contact between the first bit line and the first impurity region; a second impurity region in the substrate and spaced apart from the first impurity region; a first storage node pad on the second impurity region; and a contact insulator between the first storage node pad and a lower part of the bit-line contact, wherein the contact insulator includes a first lower contact dielectric pattern that surrounds the bit-line contact and extends beneath the first bit line; and an upper contact dielectric pattern beneath the first bit line and on the first lower contact dielectric pattern, and the upper contact dielectric pattern does not cover and exposes the first lower contact dielectric pattern on a side of the first bit line.

The disclosure includes providing a semiconductor memory device including a device isolation pattern in a substrate, the device isolation pattern defining a first active section, a second active section, and a third active section that are linearly adjacent to each other in a first direction; a first impurity region on the first active section, a second impurity region on the second active section, and a third impurity region on the third active section; a word line in the substrate, the word line running across the first active section and the second active section; a word-line capping pattern on the word line; a bit-line contact on the first active section; a contact ohmic layer between the first active section and the bit-line contact; a bit line on the bit-line contact, the bit line crossing over the word line; a first storage node pad on the second active section; a second storage node pad on the third active section; a pad separation pattern between the first storage node pad and the second storage node pad; a buried dielectric pattern between the first storage node pad and an upper part of the bit-line contact; a first lower contact dielectric pattern between the bit-line contact and the first storage node pad, the first lower contact dielectric pattern surrounding a lower part of the bit-line contact; and an upper contact dielectric pattern beneath the bit line and on the first lower contact dielectric pattern, wherein the upper contact dielectric pattern has a thickness of about 4 nm to about 10 nm.

The disclosure includes providing a method of fabricating a semiconductor memory device, the method including forming a device isolation pattern in a substrate to define a plurality of active sections; forming a plurality of first impurity regions and a plurality of second impurity regions in the plurality of active sections; forming a pad layer that covers an entire surface of the substrate; etching the pad layer to form a plurality of preliminary pads that are spaced apart from each other such that the preliminary pads overlap the second impurity regions, and the substrate and the device isolation pattern are partially exposed in a gap between the preliminary pads; forming a pad separation pattern in the gap such that the pad separation pattern has a grid shape when viewed in plan and overlaps the first impurity regions; forming an interlayer insulator on the preliminary pads and the pad separation pattern; partially etching the interlayer insulator, the pad separation pattern, and the preliminary pads on the first impurity regions to form a plurality of contact holes that expose the first impurity regions and to form a plurality of storage node pads; forming a first lower contact dielectric pattern that covers an inner sidewall of the contact hole; forming a preliminary contact that fills the contact hole; sequentially stacking a conductive layer and a capping layer on the preliminary contact; sequentially etching the capping layer and the conductive layer to form a bit-line capping pattern and a bit line and to expose the preliminary contact and the first lower contact dielectric pattern; partially removing the first lower contact dielectric pattern to form an empty space between the preliminary contact and the inner sidewall of the contact hole; and etching the preliminary contact to form a bit-line contact.

At least some of the above and other features of the invention are set out in the claims.

### BRIEF DESCRIPTION OF THE DRAWINGS

Features will be apparent to those of skill in the art by describing in detail embodiments with reference to the attached drawings in which:
FIG. 1A illustrates a plan view of a semiconductor memory device according to some embodiments.
FIG. 1B illustrates a cross-sectional view taken along lines A-A' and B-B' of FIG. 1A.
FIG. 2 illustrates an enlarged view of section PI of FIG. 1B.
The 'A' Figures in FIGS. 3A to 17A illustrate plan views of stages of a method of fabricating the semiconductor memory device of FIG. 1A.
The 'B' Figures in FIGS. 3B to 17B illustrate cross-sectional views of stages a method of fabricating the semiconductor memory device of FIG. 1B.
FIG. 18 illustrates a cross-sectional view taken along lines A-A' and B-B' of FIG. 1A.
FIG. 19 illustrates a cross-sectional view taken along lines A-A' and B-B' of FIG. 1A.
FIG. 20 illustrates an enlarged view of section PI of FIG. 19.
FIGS. 21A and 21B illustrate cross-sectional views of a method of fabricating the semiconductor memory device shown in FIG. 19.
FIG. 22 illustrates a cross-sectional view taken along lines A-A' and B-B' of FIG. 1A.
FIG. 23 illustrates an enlarged view of section PI of FIG. 22.
FIGS. 24A to 24E illustrate cross-sectional views of stages in a method of fabricating the semiconductor memory device shown in FIG. 22.
FIG. 25 illustrates a cross-sectional view taken along lines A-A' and B-B' of FIG. 1A.
FIG. 26 illustrates an enlarged view of section PI of FIG. 25.
FIGS. 27A to 27D illustrate cross-sectional views of stages in a method of fabricating the semiconductor memory device shown in FIG. 25.

### DETAILED DESCRIPTION

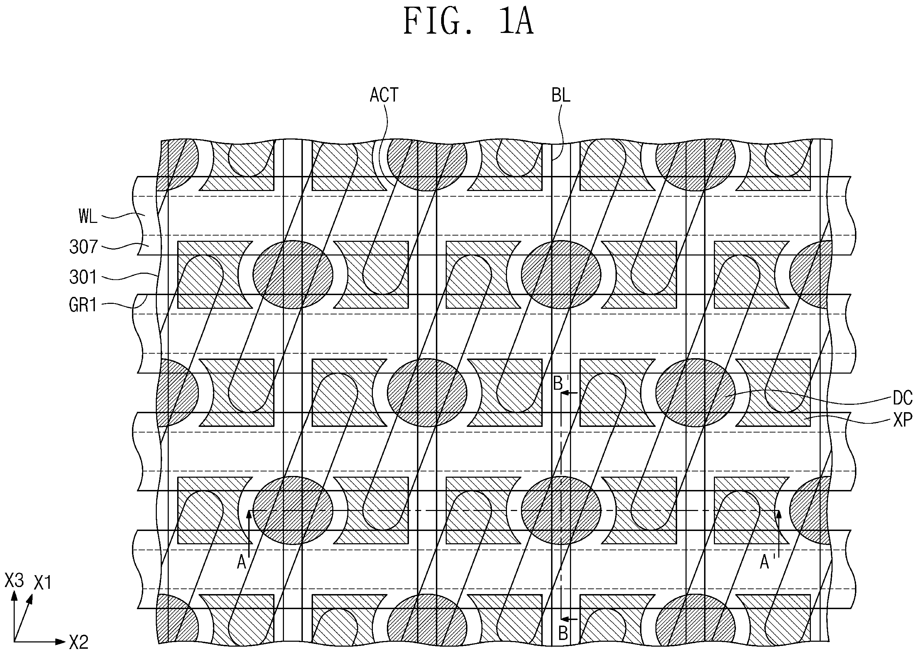

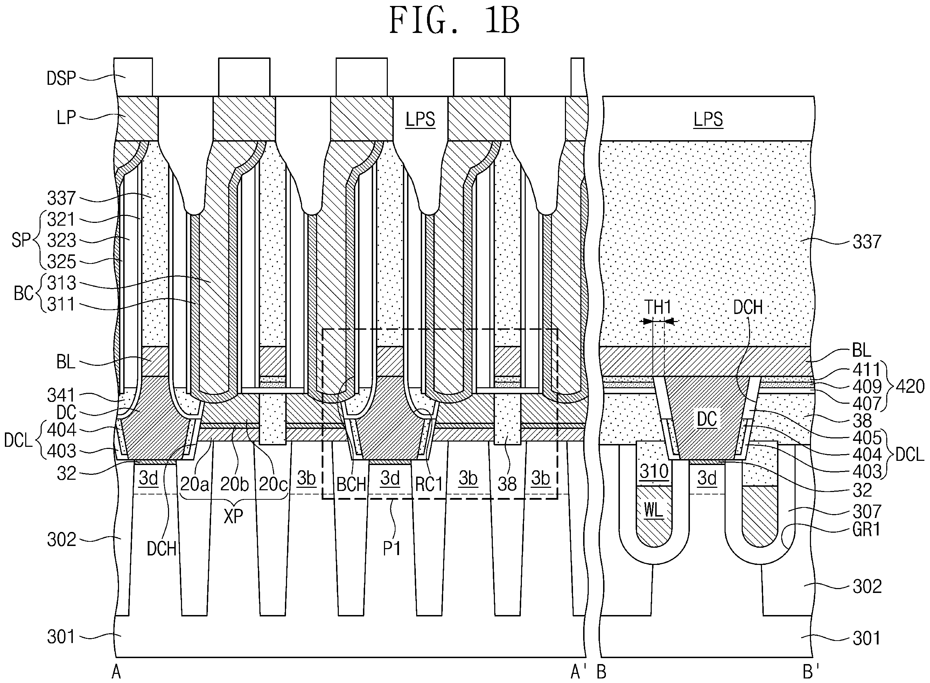

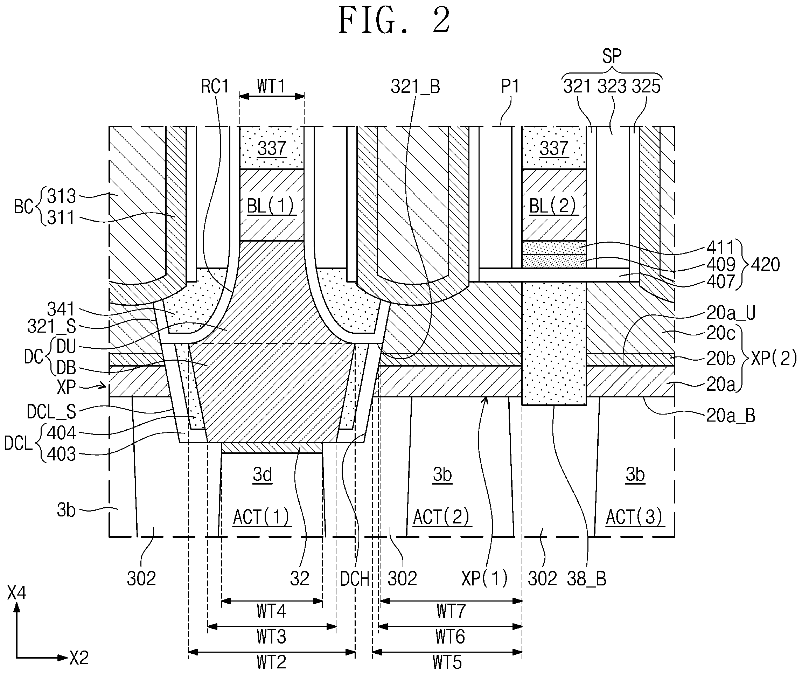

FIG. 1A illustrates a plan view of a semiconductor memory device according to some embodiments. FIG. 1B illustrates a cross-sectional view taken along lines A-A' and B-B' of FIG. 1A. FIG. 2 illustrates an enlarged view showing section PI of FIG. 1B.

Referring to FIGS. 1A and 1B, device isolation patterns 302 may be formed in a substrate 301, defining active sections ACT. Each of the active sections ACT may have an isolated shape. Each of the active sections ACT may have a bar shape elongated or extending along a first direction X1 in a plan view. When viewed in plan, the active sections ACT may correspond to portions of the substrate 301 that are surrounded by the device isolation patterns 302. The substrate 301 may include a semiconductor material. The active sections ACT may be arranged parallel to each other in the first direction X1, such that one of the active sections ACT may have an end adjacent to a central portion of a neighboring one of the active sections ACT. Each of the device isolation patterns 302 may have a single-layered or multi-layered structure formed of, e.g., silicon oxide, silicon oxynitride, or silicon nitride. As used herein, the term "or" is not an exclusive term, e.g., "A or B" would include A, B, or A and B.

Word lines WL may run across the active sections ACT. The word lines WL may be in grooves GR1 in the device isolation patterns 302 and in the active sections ACT. The word lines WL may be parallel to a second direction X2 that intersects the first direction X1. The word lines WL may be formed of a conductive material. A gate dielectric layer 307 may be between each of the word lines WL and an inner surface of each groove GR1. In an implementation, the grooves GR1 may have bottom surfaces that are relatively deeper in the device isolation patterns 302 and relatively shallower in the active sections ACT. The word lines WL may have curved bottom surfaces. The gate dielectric layer 307 may include, e.g., a thermal oxide, silicon nitride, silicon oxynitride, or a high-k dielectric. In an implementation, the gate dielectric layer 307 may include, e.g., a thermal oxide.

A first impurity region 3d may be in each active section ACT between a pair of word lines WL, and a pair of second impurity regions 3b may be correspondingly in opposite edge portions of each of the active sections ACT. The first and second impurity regions 3d and 3b may be doped with, e.g., N-type impurities. The first impurity region 3d may correspond to a common drain region, and the second impurity regions 3b may correspond to source regions. A transistor may be constituted by one of the word lines WL and its adjacent first and second impurity regions 3d and 3b. In an implementation, the word lines WL may be in the grooves GR1, and each of the word lines WL may have thereunder a channel region whose length becomes increased within a limited planar area. Accordingly, a short-channel effect may be minimized.

A word-line capping pattern 310 may be on each of the word lines WL. The word-line capping patterns 310 may have linear shapes that extend along longitudinal directions of the word lines WL, and may cover entire top surfaces (e.g., surfaces facing away from the substrate 301) of the word lines WL. The word-line capping patterns 310 may fill (e.g., remaining parts of) the grooves GR1 on the word lines WL. The word-line capping patterns 310 may be formed of, e.g., a silicon nitride layer.

Bit lines BL may be on the substrate 301. The bit lines BL may run across the word-line capping patterns 310 and the word lines WL. In an implementation, as illustrated in FIG. 1A, the bit lines BL may be parallel to a third direction X3 that intersects the first and second directions X1 and X2. The bit line BL may include a conductive layer. In an implementation, the bit line BL may include a first metal or first metal-containing material. In an implementation, the bit line BL may include, e.g., titanium, tantalum, ruthenium, molybdenum, tantalum nitride, tungsten, aluminum, or copper.

Bit-line contacts DC may be correspondingly provided between the bit lines BL and the active sections ACT in which the first impurity regions 3d are doped. In an implementation, referring to FIG. 2, the bit-line contact DC may be between a first active section ACT(1) and a first bit line BL(1) that is one of the bit lines BL. The bit-line contact DC may be in a bit-line contact hole DCH. The bit-line contact DC may include a second metal or a second metal-containing material. The second metal may be identical to or different from the first metal. In an implementation, the bit-line contact DC may include, e.g., titanium, tantalum, ruthenium, molybdenum, tantalum nitride, tungsten, aluminum, or copper. In an implementation bit-line contact DC may be formed of, e.g., titanium nitride. In an implementation, the bit-line contact DC may be formed of a double-layered structure of, e.g., a titanium layer and a titanium nitride layer.

In an implementation, the bit line BL and the bit-line contact DC may each include a metal, the bit line BL and the bit-line contact DC may have low resistance, and thus the semiconductor memory device may increase in operating speed and may operate at low power. If one or both of the bit line BL and the bit-line contact DC were to include polysilicon, depletion issues due to polysilicon could occur when applying voltage to one or both of the bit line BL and the bit-line contact DC, and thus a reduction in electrical path could occur. Therefore, bit-line necking or electrical cut-off due to electrical resistance could occur. In an implementation, the bit line BL and the bit-line contact DC may each include a metal, and thus the bit-line necking issue may be addressed.

As shown in FIG. 1A, the bit-line contact DC may have a circular or oval shape when viewed in plan. The bit-line contact DC may have a planar area greater than that of a location where the bit line BL overlaps the first impurity region 3d. The planar area of the bit-line contact DC may be greater than that of the first impurity region 3d.

Referring to FIGS 1B and 2, the bit-line contact DC may have a lower part DB and an upper part DU that are integrally connected into a unitary single part (e.g., a monolithic structure). No interface may be present between the lower and upper parts DB and DU of the bit-line contact DC. The bit-line contact DC may have a first width WT1 (as measured in the second direction X2) at a top surface (e.g., surface facing away from or distal to the substrate 301) thereof. The upper part DU of the bit-line contact DC may have a width (as measured in the second direction X2) that increases in a downward direction (e.g., at different points along a vertical or fourth direction X4 extending toward the substrate 301). The bit-line contact DC may include a recess RC1 on a sidewall of the upper part DU. The lower part DB of the bit-line contact DC may have a width (as measured in the second direction X2) that decreases in a downward direction (e.g., at different points along the vertical or fourth direction X4 extending toward the substrate 301). The bit-line contact DC may have a second width WT2 (as measured in the second direction X2) at a portion or plane where the upper part DU and the lower part DB meet each other. The second width WT2 may be greater than the first width WT1. The bit-line contact DC may have a third width WT3 (as measured in the second direction X2) at a bottom surface (e.g., surface facing or proximate to the substrate 301) thereof. The second width WT2 may be greater than the third width WT3.

A contact ohmic layer 32 may be between the bit-line contact DC and the first impurity region 3d. The contact ohmic layer 32 may be formed of, e.g., titanium silicide. In an implementation, the contact ohmic layer 32 may have a sidewall that is not aligned with (e.g., laterally or inwardly offset from, in the second direction X2) that of the lower part DB of the bit-line contact DC. The contact ohmic layer 32 may have a fourth width WT4 at a bottom surface thereof. The fourth width WT4 may be less than the third width WT3. This helps decrease a contact resistance between the bit-line contact DC and the substrate 301. The first active section ACT(1) beneath the contact ohmic layer 32 may also have the fourth width WT4. In an implementation, the first active section ACT(1) beneath the contact ohmic layer 32 may have the fourth width WT4, e.g., the same as that of the contact ohmic layer 32.

A storage node pad XP may be on the active section ACT doped with the second impurity region 3b. The storage node pad XP may include a pad silicon layer 20a, a pad ohmic layer 20b, and a pad metal layer 20c that are sequentially stacked. The pad silicon layer 20a may include a polysilicon layer doped with impurities. The pad ohmic layer 20b may include metal silicide, e.g., cobalt silicide or titanium silicide. The pad metal layer 20c may include a third metal or metal-containing material. In an implementation, the pad metal layer 20c may include, e.g., titanium, tantalum, ruthenium, molybdenum, tantalum nitride, tungsten, aluminum, or copper. The storage node pad XP may have an oblique or inclined sidewall. The storage node pad XP may have a width that increases in a downward direction. The pad silicon layer 20a of the storage node pad XP may have a fifth width WT5 at a bottom (e.g., substrate 301-facing) surface 20a_B thereof. The pad ohmic layer 20b may have a sixth width WT6 at a bottom surface thereof. The pad metal layer 20c may have a seventh width WT7 at a bottom surface thereof. The sixth width WT6 may be less than the fifth width WT5 and may be greater than the seventh width WT7.

In an implementation, as shown in FIG. 1A, the storage node pad XP may have four lateral surfaces when viewed in plan, and may be concave at one of the four lateral surfaces that is adjacent to or faces the bit-line contact DC. The storage node pad XP may overlap the gate dielectric layer 307.

In an implementation, the storage node pad XP may include the pad metal layer 20c, and the storage node pad XP may decrease in electrical resistance. Accordingly, a semiconductor memory device may increase in operating speed and may operate at low power.

A contact insulator DCL may be between the lower part DB of the bit-line contact DC and the storage node pad XP that is adjacent to the lower part DB of the bit-line contact DC. In an implementation, the contact insulator DCL may include a first lower contact dielectric pattern 403 and a second lower contact dielectric pattern 404. The first lower contact dielectric pattern 403 may cover a sidewall and a bottom surface of the second lower contact dielectric pattern 404. The first lower contact dielectric pattern 403 may include a material having an etch selectivity with respect to the second lower contact dielectric pattern 404. In an implementation, the first and second lower contact dielectric patterns 403 and 404 may include, e.g., a material whose dielectric constant is less than that of silicon nitride. In an implementation, the first lower contact dielectric pattern 403 may include silicon oxide. The second lower contact dielectric pattern 404 may include SiOC. In an implementation, insulating properties of the contact insulator DCL may be increased to help reduce inference between the bit-line contact DC and the storage node pad XP, and thus it may be possible to improve BBD (bit line to buried contact disturbance) properties and to increase reliability of a semiconductor memory device.

The first and second lower contact dielectric patterns 403 and 404 may have top ends higher (e.g., farther from the substrate 301 in the fourth direction X4) than a top surface 20a_U of the pad silicon layer 20a or a top surface of the pad ohmic layer 20b. The first and second lower contact dielectric patterns 403 and 404 may have bottom ends lower (e.g., closer to the substrate 301 in the fourth direction X4) than the bottom surface 20a_B of the pad silicon layer 20a. The bottom end of the first lower contact dielectric pattern 403 may be lower than the bottom end of the second lower contact dielectric pattern 404. The bottom end of the first lower contact dielectric pattern 403 may be at the same level as that of the bottom surface of the bit-line contact DC. The contact insulator DCL may have a bottom end that is higher than the bottom surface of the contact ohmic layer 32.

A buried dielectric pattern 341 may be between the upper part DU of the bit-line contact DC and the storage node pad XP that is adjacent to the upper part DU of the bit-line contact DC. The bit line BL may have a sidewall covered with a bit-line spacer SP. The bit-line spacer SP may include a first spacer 321, a second spacer 323, and a third spacer 325 that are sequentially disposed on the sidewall of the bit line BL. The first spacer 321 may downwardly extend to be between the buried dielectric pattern 341 and the upper part DU of the bit-line contact DC, between the buried dielectric pattern 341 and the contact insulator DCL, and between the buried dielectric pattern 341 and the storage node pad XP. The first spacer 321 may have a bottom end 321_B higher than a top surface 20a_U of the pad silicon layer 20a or the top surface of the pad ohmic layer 20b. The first spacer 321 may have an outer sidewall 321_S aligned with a sidewall DCL_S of the contact insulator DCL on a side of the bit line BL.

The buried dielectric pattern 341 and the first, second, and third spacers 321, 323, and 325 may each independently be formed of, e.g., silicon nitride, silicon oxide, silicon oxynitride, or SiOC. In an implementation, the buried dielectric pattern 341 and the third spacer 325 may be formed of a material having an etch selectivity with respect to the first and second spacers 321 and 323. The buried dielectric pattern 341 and the third spacer 325 may be formed of, e.g., silicon nitride. The first and second spacers 321 and 323 may include a material, e.g., silicon oxide, whose dielectric constant is less than that of silicon nitride. In an implementation, when the bit-line spacer SP has an increase in ratio of silicon oxide to silicon nitride, the bit-line spacer SP may have increased insulating properties. In an implementation, there may be a reduction in interference between the bit line BL and a storage node contact BC which will be discussed below. Accordingly, it may be possible to improve the BBD (bit line to buried contact disturbance) properties and to increase reliability of a semiconductor memory device.

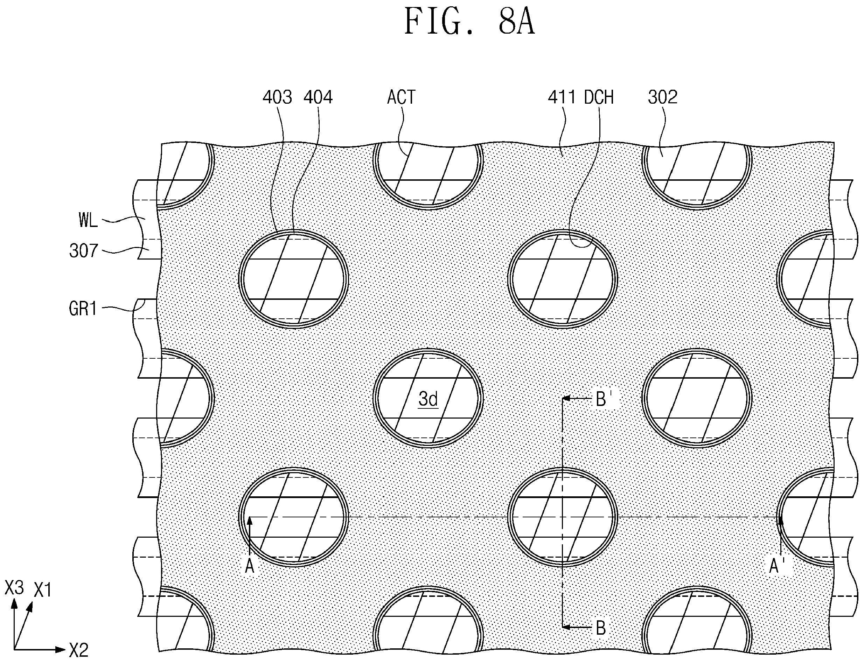

When viewed in plan as shown in FIG. 8A, the first and second lower contact dielectric patterns 403 and 404 of the contact insulator DCL may each have an annular (e.g., closed loop) shape and may surround the bit-line contact DC. The bit line BL may be provided thereunder with the contact insulator DCL that includes an upper contact dielectric pattern 405 on the first and second lower contact dielectric patterns 403 and 404, as shown in FIG. 1B. The upper contact dielectric pattern 405 may include, e.g., silicon oxide. The upper contact dielectric pattern 405 may have a thickness TH1 that is the same as a sum of thicknesses of the first lower contact dielectric pattern 403 and the second lower contact dielectric pattern 404. The thickness TH1 of the upper contact dielectric pattern 405 may range, e.g., from about 4 nm to about 10 nm. Below the bit line BL, the upper contact dielectric pattern 405 may be between the bit-line contact DC and a pad separation pattern 38.

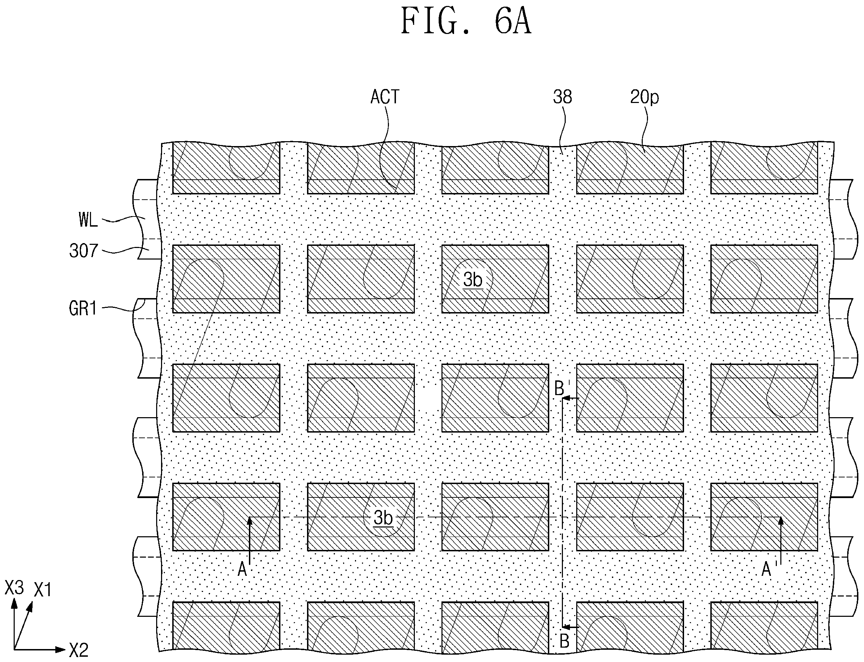

Referring to FIG. 2, a first active section ACT(1), a second active section ACT(2), and a third active section ACT(3) may be linearly disposed (e.g., spaced apart) along the second direction X2. The pad separation pattern 38 may be between neighboring storage node pads XP, e.g., between a first storage node pad XP(1) and a second storage node pad XP(2). The pad separation pattern 38 may have a network or grid shape when viewed in plan as shown in FIG. 6A. The pad separation pattern 38 may include a dielectric material, e.g., silicon nitride, silicon oxide, or silicon oxynitride. A portion of the pad separation pattern 38 may protrude into the device isolation pattern 302, as shown in FIG. 2. The pad separation pattern 38 may have a bottom surface 38_B lower than the bottom surface 20a_B of the pad silicon layer 20a.

A second bit line BL(2) may be on the pad separation pattern 38. An interlayer insulator 420 may be between the second bit line BL(2) and the pad separation pattern 38. The interlayer insulator 420 may include first, second, and third interlayer dielectric layers 407, 409, and 411 that are sequentially stacked. The second and third interlayer dielectric layers 409 and 411 may have sidewalls that are aligned with those of the bit line BL. In an implementation, the first interlayer dielectric layer 407 may have a width (e.g., in the second direction X2) greater than those of the second and third interlayer dielectric layers 409 and 411. The first interlayer dielectric layer 407 may have a sidewall aligned with sidewalls (e.g., outer sidewalls) of the second spacer 323. Each of the first, second, and third interlayer dielectric layers 407, 409, and 411 may include a dielectric material having an etch selectivity with respect to a material included in another one of the first, second, and third interlayer dielectric layers 407, 409, and 411. The first, second, and third interlayer dielectric layers 407, 409, and 411 may include materials different from each other. In an implementation, the first interlayer dielectric layer 407 may include silicon oxide or silicon nitride. In an implementation, the second interlayer dielectric layer 409 may include metal oxide. In an implementation, the metal oxide may include, e.g., hafnium oxide, aluminum oxide, ruthenium oxide, or iridium oxide. In an implementation, the third interlayer dielectric layer 411 may include silicon nitride.

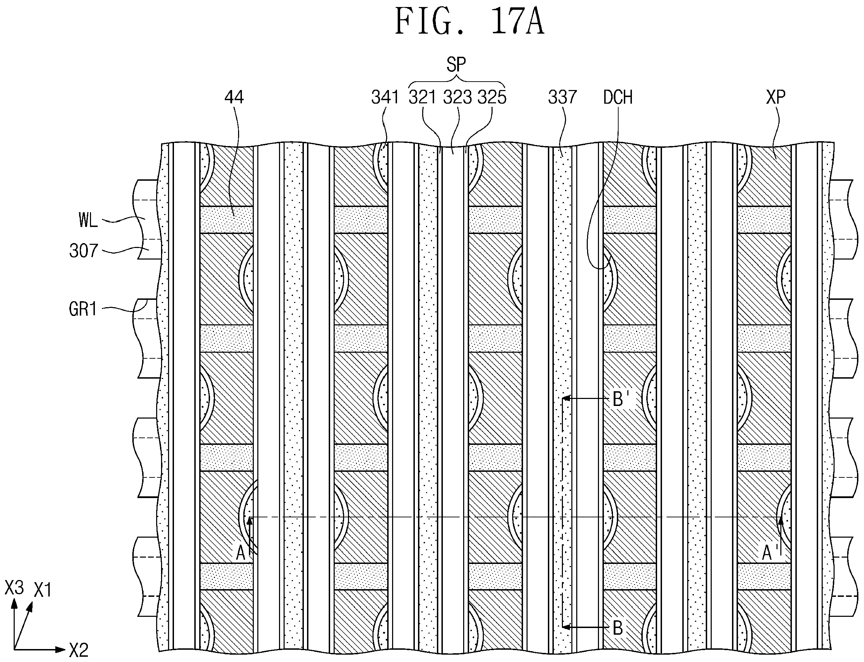

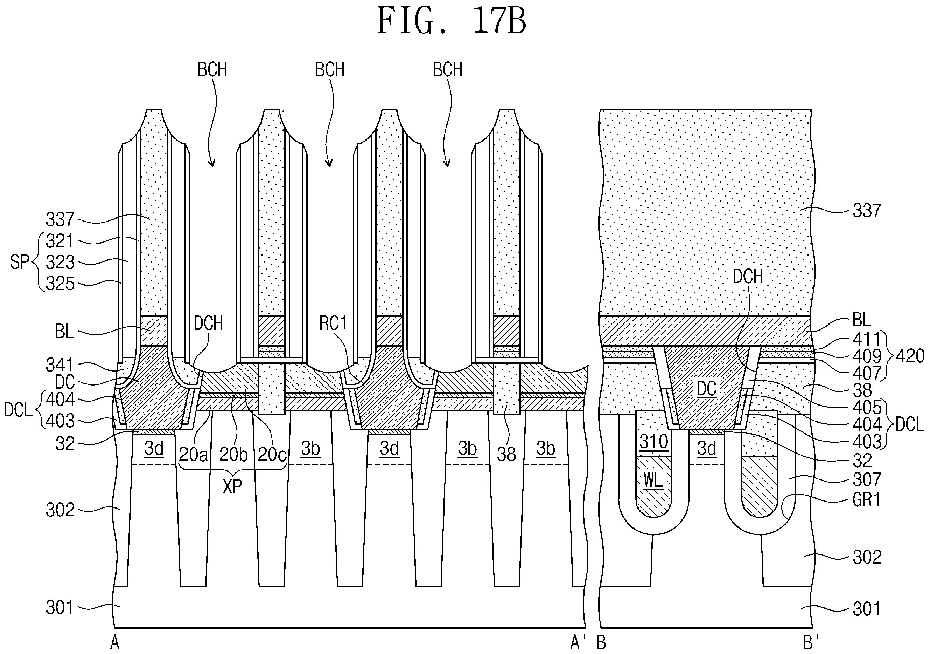

A storage node contact BC may be between neighboring bit lines BL. The storage node contact BC may be in a storage node contact hole BCH between neighboring bit lines BL. In an implementation, a plurality of node separation patterns 44 may be between neighboring bit-line spacers SP, e.g., as illustrated in FIGS. 17A and 17B. The node separation patterns 44 may be linearly arranged and spaced apart from each other between the bit-line spacers SP. The node separation patterns 44 may overlap the word lines WL. The storage node contact holes BCH may be defined between the bit-line spacers SP and between the node separation patterns 44. The node separation patterns 44 may include a dielectric material, e.g., silicon nitride, silicon oxynitride, or silicon oxide.

The storage node contact BC may include a contact metal pattern 313 and a contact diffusion barrier pattern 311 that surrounds a sidewall and a bottom surface (e.g., outer sides) of the contact metal pattern 313, as shown in FIG. 2. The contact diffusion barrier pattern 311 may have a uniform thickness irrespective of position or may conformally cover a sidewall and a bottom surface of the storage node contact hole BCH. The storage node contacts BC may exclude polysilicon. The contact diffusion barrier pattern 311 may include a fourth metal. The contact metal pattern 313 may include a fifth metal. In an implementation, the fourth metal and the fifth metal may be the same as or different from the third metal. In an implementation, the contact diffusion barrier pattern 311 and the contact metal pattern 313 may each independently include, e.g., titanium, tantalum, ruthenium, molybdenum, tantalum nitride, tungsten, aluminum, or copper. The contact diffusion barrier pattern 311 may include, e.g., titanium, titanium nitride (TiN), titanium silicon nitride (TiSiN), tantalum, tantalum nitride, or tungsten nitride. In an implementation, the contact metal pattern 313 may include, e.g., tungsten, aluminum, or copper. The contact diffusion barrier pattern 311 may be rounded on its bottom surface. The contact metal pattern 313 may also be rounded on its bottom surface.

An increase in amount of polysilicon in the storage node contact BC could cause or allow the storage node contact BC to have an electrical resistance relatively greater than that of metal, and thus tRDL (Last Data-in to Row pre-charge Timing) defects could become greater. In contrast, according to an embodiment, the storage node contact BC may exclude (e.g., may be essentially free of) polysilicon, and may include a metal, the storage node contact BC may exhibit a decrease in electrical resistance to improve tRDL defects. In an implementation, the storage node contact BC may be essentially free of polysilicon, and an annealing process for crystallization of polysilicon may be omitted, with the result that fabrication process may be simplified. In an implementation, the +storage node contact BC may be essentially free of polysilicon and may include a metal, processes (e.g., metal deposition) other than the annealing process may be performed at low temperatures. Such low-temperature processes may use silicon oxide to form the first spacer 321, and thus the bit-line spacer SP may exhibit increased insulating properties.

Referring to FIG. 1B, landing pads LP may be on corresponding storage node contacts BC. When viewed in plan, the landing pads LP may each have an isolated island shape. The landing pad LP may be in contact simultaneously with a top surface of the contact diffusion barrier pattern 311, a top surface of a bit-line capping pattern 337, and a top surface of the contact metal pattern 313. The landing pad LP may include, e.g., the same material as that of the contact metal pattern 313. Landing pad separation patterns LPS may be between the landing pads LP. A portion of the landing pad separation pattern LPS may be between the storage node contact BC and the bit-line spacer SP that are adjacent to each other. Therefore, the landing pad separation patterns LPS may have their bottom ends lower than a top end of the bit-line spacer SP.

Data storage patterns DSP may be on corresponding landing pads LP. The data storage patterns DSP may each be a capacitor including a bottom electrode, a dielectric layer, and a top electrode. In this case, a semiconductor memory device may be a dynamic random access memory (DRAM). In an implementation, the data storage patterns DSP may each include a magnetic tunnel junction pattern. In this case, a semiconductor memory device may be a magnetic random access memory (MRAM). In an implementation, the data storage patterns DSP may each include a phase change material or a variable resistance material. In this case, a semiconductor memory device may be a phase change random access memory (PRAM) or a resistive random access memory (ReRAM).

In an implementation, the storage node contact BC and the storage node pad XP may all include a metal, and a metal-to-metal bonding may be provided between the storage node contact BC and the storage node pad XP, which may result in a significant reduction in electrical resistance. In an implementation, the bit line BL and the bit-line contact DC may all include a metal, and a metal-to-metal bonding may be provided between the bit line BL and the bit-line contact DC, which may result in a significant reduction in electrical resistance. Therefore, bit-line necking, BBD (bit line to buried contact disturbance), and tRDL properties may be improved, and a semiconductor memory device may increase in operating speed and may operate at low powers.

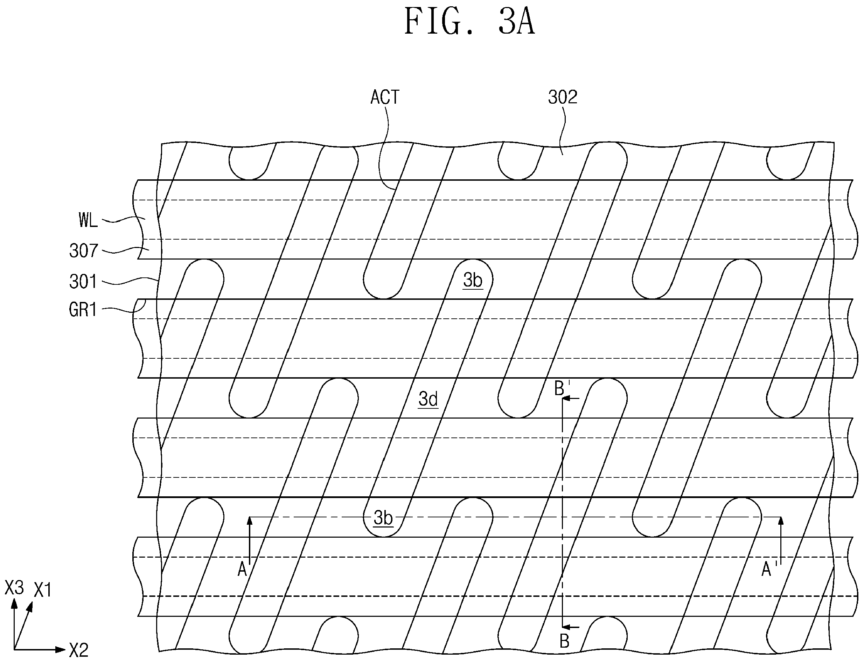

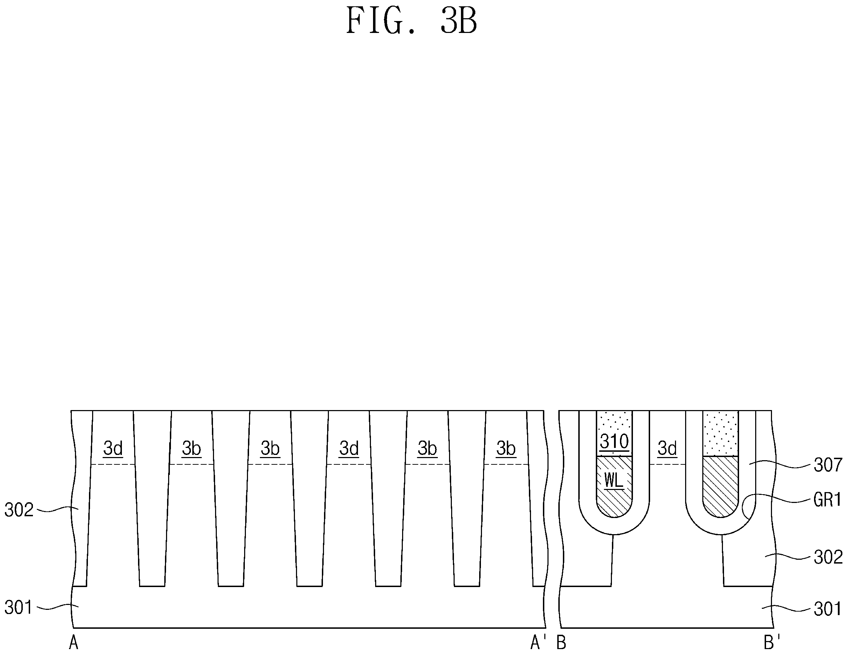

The 'A' figures in FIGS. 3A to 17A illustrate plan views of stages in a method of fabricating the semiconductor memory device of FIG. 1A. The 'B' figures in FIGS. 3B to 17B illustrate cross-sectional views of stages in a method of fabricating the semiconductor memory device of FIG. 1B. FIGS. 3B to 17B depict cross-sectional views taken along lines A-A' and B-B' of FIGS. 3A to 17A, respectively.

Referring to FIGS. 3A and 3B, device isolation patterns 302 may be formed in a substrate 301, defining active sections ACT. A device isolation trench may be formed in the substrate 301, and the device isolation patterns 302 may fill the device isolation trench. The active sections ACT and the device isolation patterns 302 may be patterned to form grooves GR1. In this step, an etching condition of the substrate 301 and the device isolation patterns 302 may be properly controlled such that the device isolation patterns 302 may be more easily etched than the substrate 301. Therefore, the grooves GR1 may have curved bottom surfaces. A gate dielectric layer 307 may be conformally formed in the grooves GR1. The gate dielectric layer 307 may be formed by, e.g., thermal oxidation, chemical vapor deposition, or atomic layer deposition. A gate conductive layer may be stacked or formed to fill the grooves GR1 and may then be etched-back to form word lines WL. A pair of word lines WL may run across each of the active sections ACT. A dielectric layer, e.g., a silicon nitride layer, may be stacked on the substrate 301 so as to fill the grooves GR1, and then the dielectric layer may be etched to form a word-line capping pattern 310 on each of the word lines WL. The word-line capping patterns 310 and the device isolation patterns 302 may be used as a mask to dope impurities into the active sections ACT, which may form first and second impurity regions 3d and 3b.

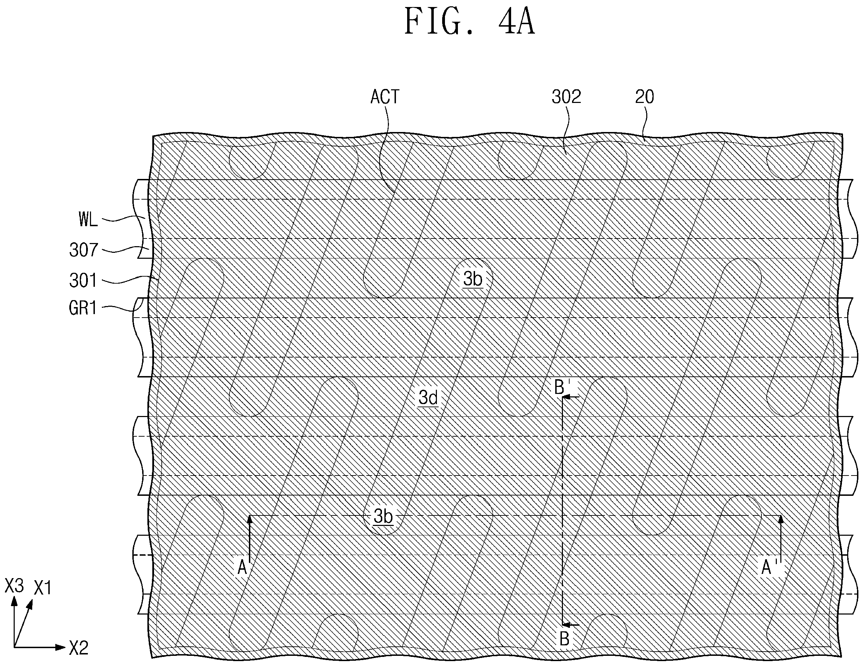

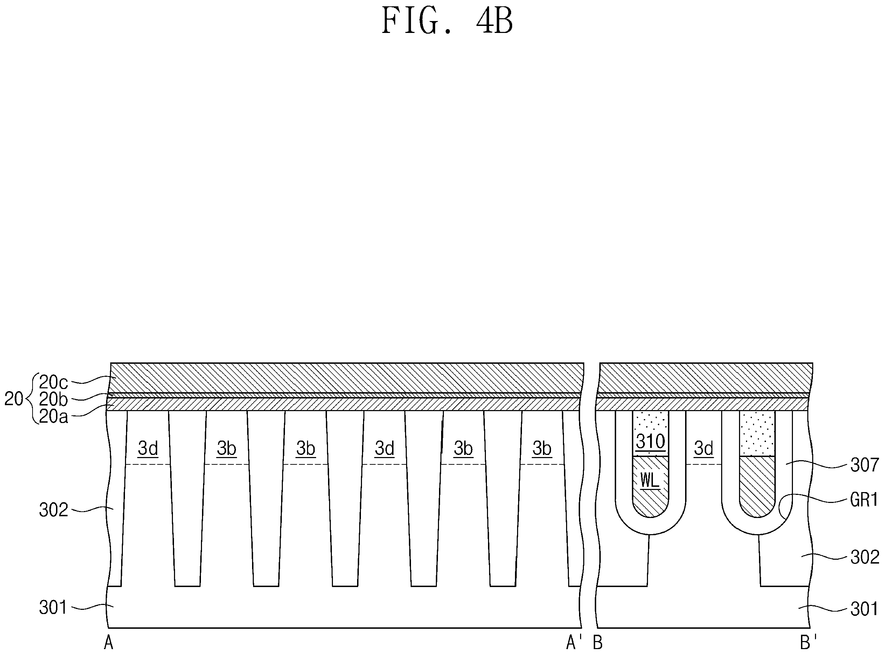

Referring to FIGS. 4A and 4B, a pad layer 20 may be formed on the substrate 301. The pad layer 20 may be formed by sequentially stacking a pad silicon layer 20a, a pad ohmic layer 20b, and a pad metal layer 20c. The pad silicon layer 20a may be formed of an impurity-doped polysilicon layer. The pad ohmic layer 20b may be formed of a metal silicide layer. The pad ohmic layer 20b may be formed by forming a metal layer on the pad silicon layer 20a, and then performing an annealing process on the metal layer. Portions of the metal layer that were not changed into metal silicide in the annealing process may be removed. In an implementation, the pad metal layer 20c may be directly formed on the pad silicon layer 20a. The pad ohmic layer 20b may be formed at an interface between the pad silicon layer 20a and the pad metal layer 20c. In an implementation, the pad ohmic layer 20b may be formed simultaneously with stacking the pad metal layer 20c. The pad layer 20 may be formed flat without any step difference.

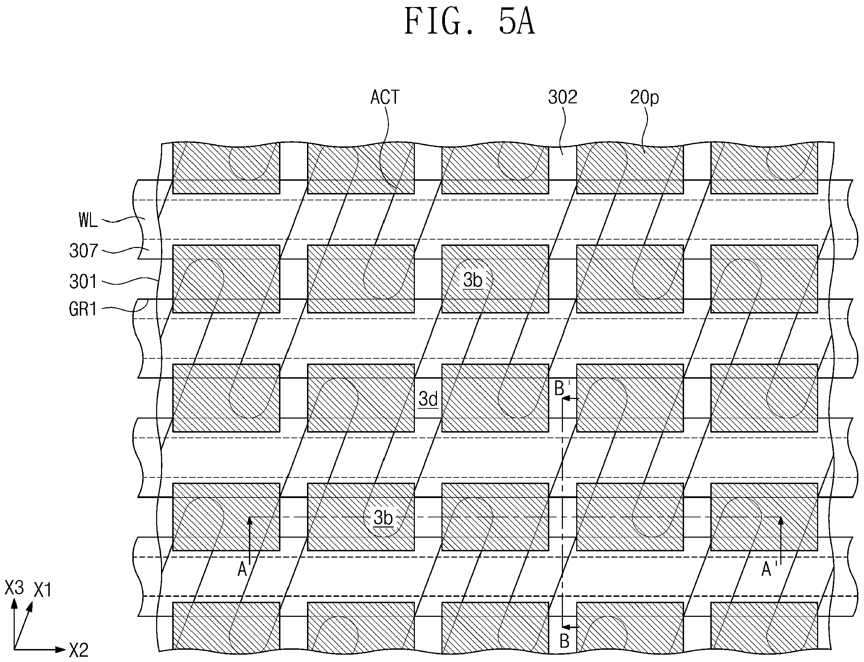

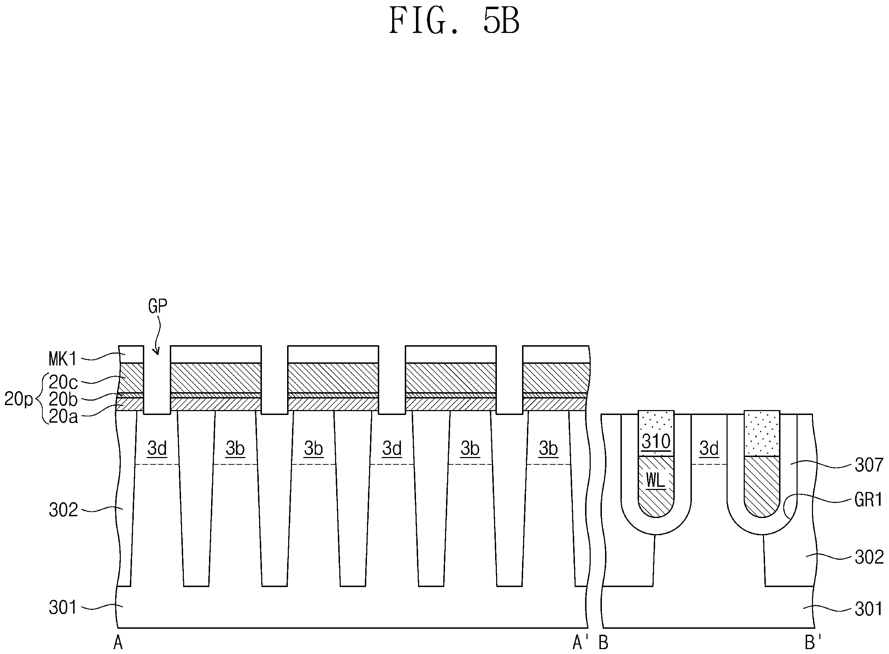

Referring to FIGS. 5A and 5B, mask patterns MK1 may be formed on the pad layer 20. The mask patterns MK1 may include a material (e.g., silicon oxide, silicon nitride, or silicon oxynitride) that has an etch selectivity with respect to the pad layer 20. The mask patterns MK1 may be formed to have rectangular shapes that are twodimensionally arranged along a second direction X2 and a third direction X3 to thereby constitute an array. The mask patterns MK1 may overlap the second impurity regions 3b. An etching process may be performed, in which the mask patterns MK1 are used as an etching mask, to etch the pad layer 20 to form preliminary pads 20p and also to form gaps GP between the preliminary pads 20p. The pad layer 20 may be formed flat without any step difference, and defects may be avoided in the etching process. The gaps GP may partially expose the device isolation pattern 302, the active sections ACT, the word-line capping pattern 310, and the gate dielectric layer 307.

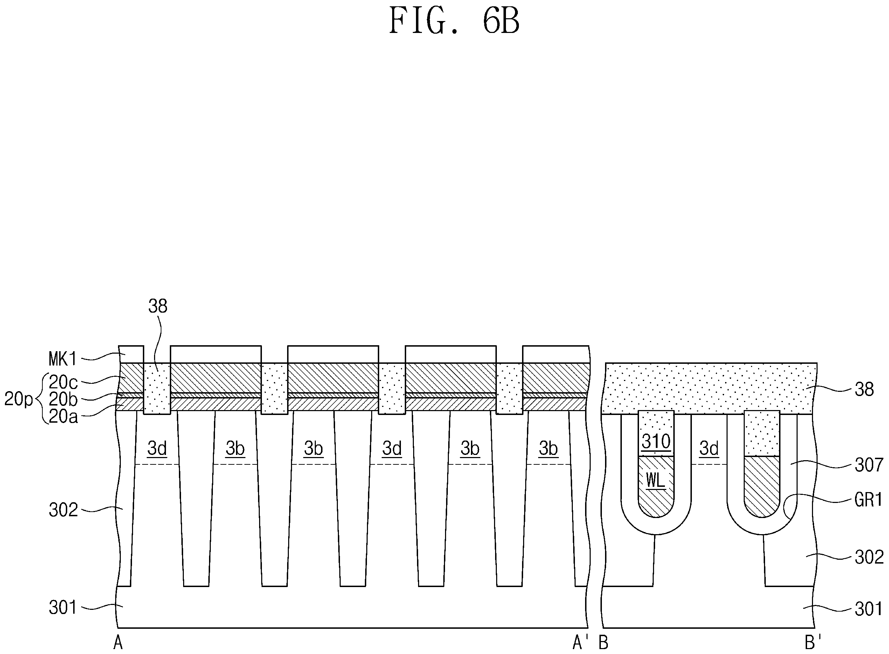

Referring to FIGS. 6A and 6B, a pad separation layer may fill the gaps GP, and then the pad separation layer may be etched to form a pad separation pattern 38 in the gaps GP. The pad separation pattern 38 may have a grid shape when viewed in plan.

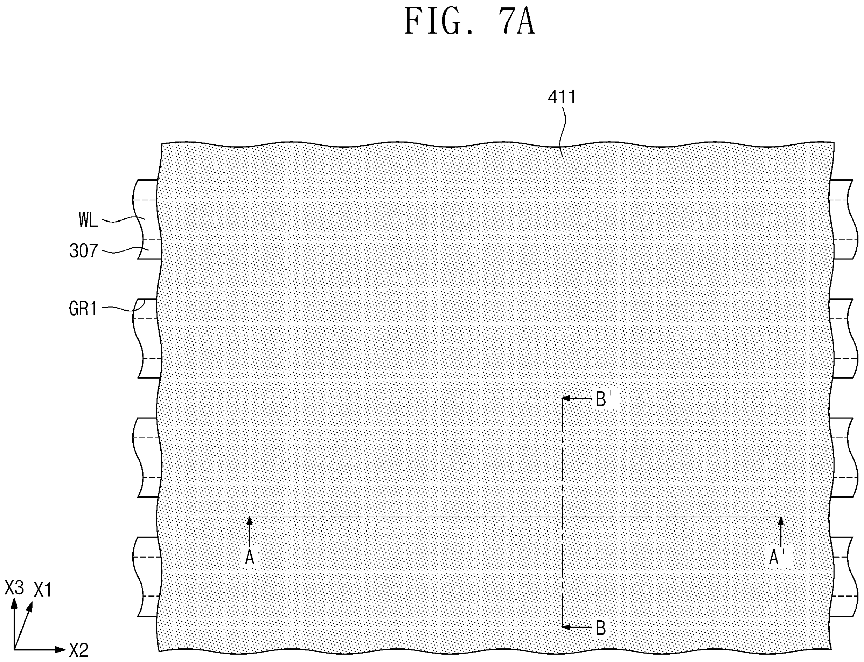

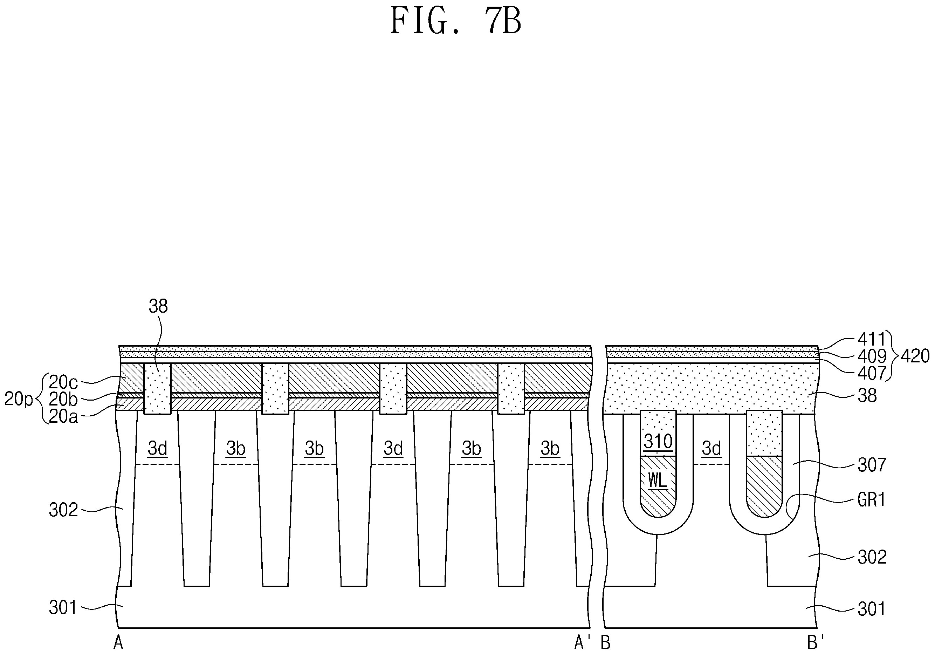

Referring to FIGS. 7A and 7B, the mask patterns MK1 may be removed to expose top surfaces of the preliminary pads 20p. An interlayer insulator 420 may be formed on the preliminary pads 20p and the pad separation pattern 38. The interlayer insulator 420 may include first, second, and third interlayer dielectric layers 407, 409, and 411 that are sequentially stacked. In an implementation, the first interlayer dielectric layer 407 may include silicon oxide or silicon nitride, and the second interlayer dielectric layer 409 may include metal oxide. The third interlayer dielectric layer 411 may include silicon nitride.

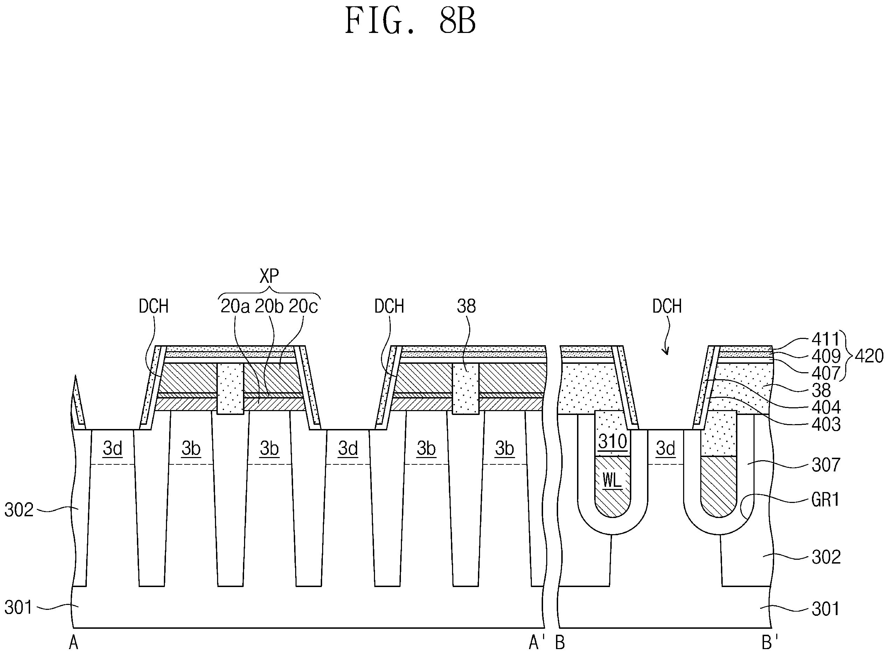

Referring to FIGS. 8A and 8B, the pad separation pattern 38 and the interlayer insulator 420 on the first impurity regions 3d may be etched to form contact holes DCH that expose the first impurity regions 3d. In this step, the preliminary pads 20p adjacent to the pad separation pattern 38 may also be partially etched to form storage node pads XP. A first lower contact dielectric layer and a second lower contact dielectric layer may be sequentially conformally formed on an entire surface of the substrate 301, and then the first and second lower contact dielectric layers may undergo an anisotropic etching process to form a first lower contact dielectric pattern 403 and a second lower contact dielectric pattern 404 that sequentially cover inner walls of the contact holes DCH. Each of the first and second lower contact dielectric patterns 403 and 404 may be formed of a material having an etch selectivity with respect to a material of another one of the first and second lower contact dielectric patterns 403 and 404. In an implementation, the first lower contact dielectric pattern 403 may include silicon oxide, and the second lower contact dielectric pattern 404 may include SiOC.

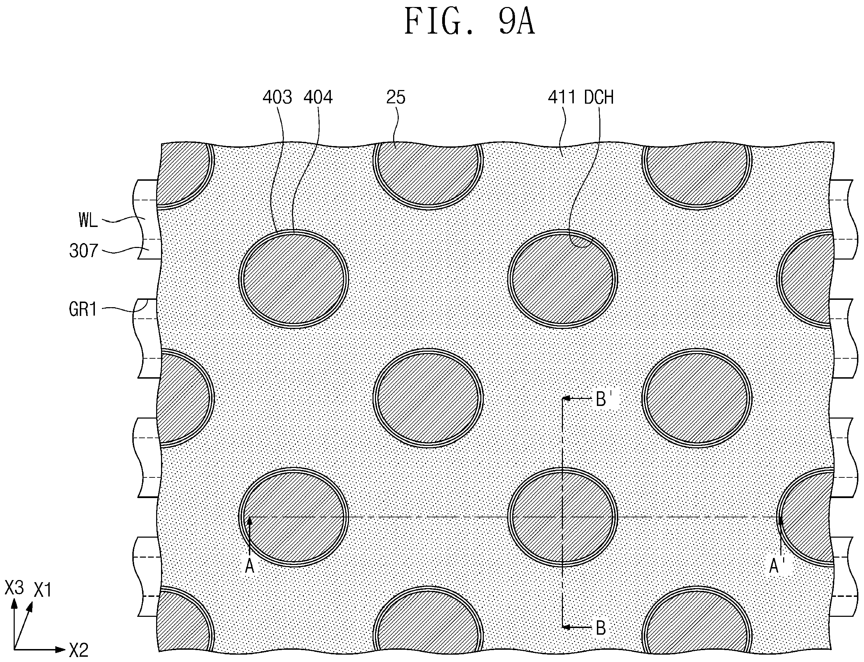

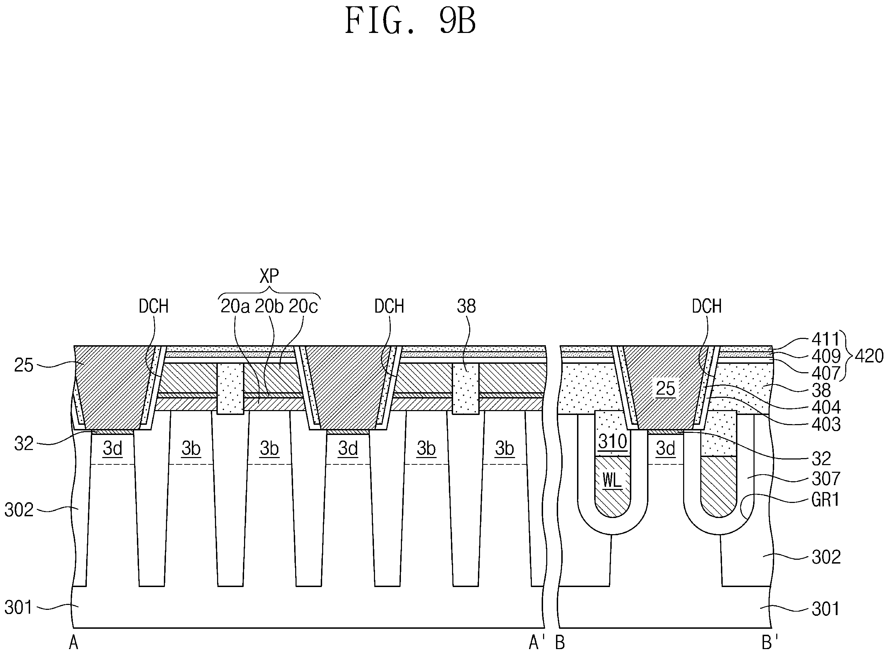

Referring to FIGS. 9A and 9B, a metal layer may be formed on the entire surface of the substrate 301, filling the contact hole DCH. While the metal layer is formed, the metal layer and a surface of the substrate 301 may react with each other to form a contact ohmic layer 32 on a bottom surface of the contact hole DCH. After the metal layer is formed, a chemical mechanical polishing process or an etch-back process may be performed to expose a top surface of the interlayer insulator 420 and at the same time to form a preliminary contact 25 in the contact hole DCH. In this step, there may be exposed top surfaces of the first and second lower contact dielectric patterns 403 and 404.

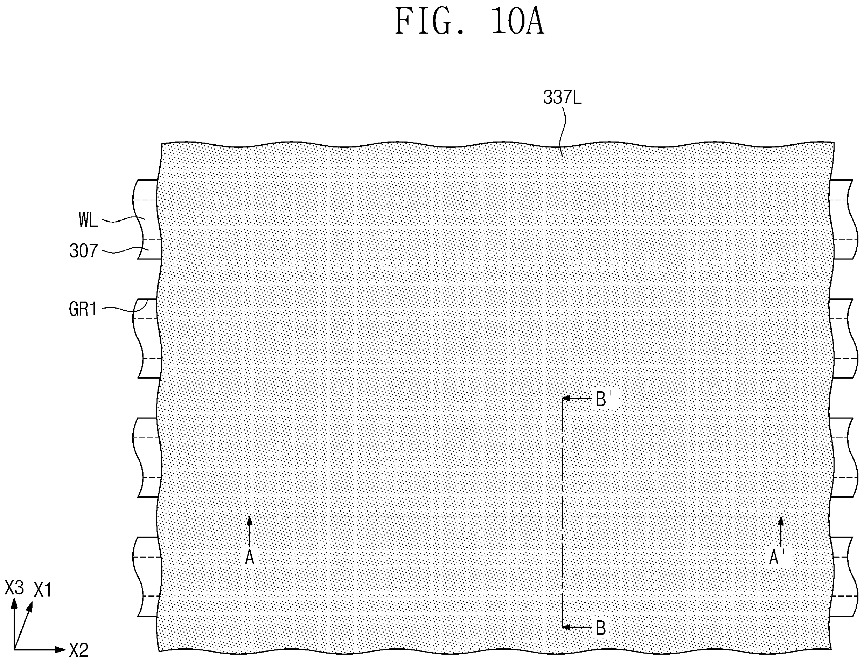

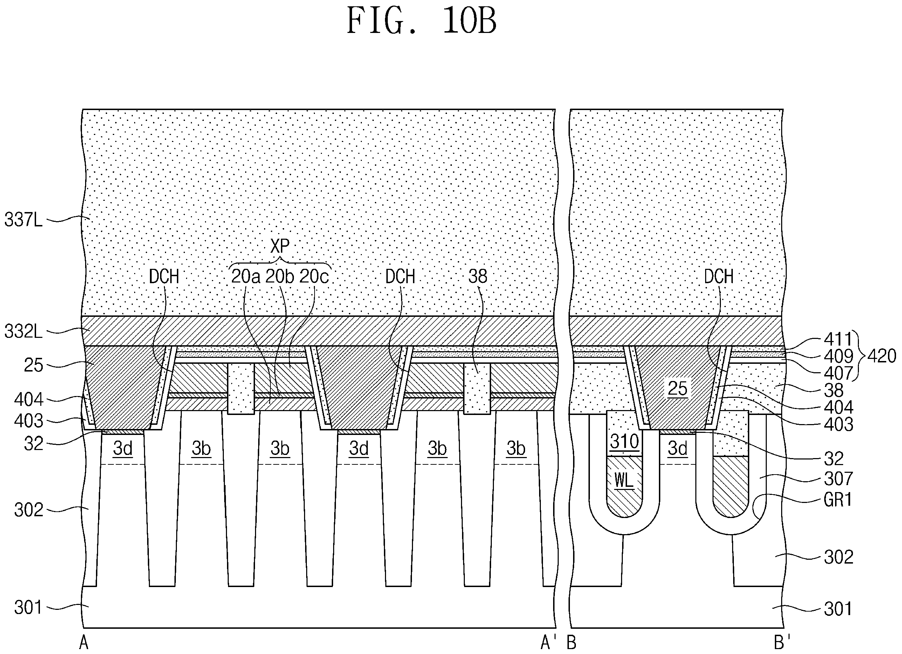

Referring to FIGS. 10A and 10B, a bit-line layer 332L and a bit-line capping layer 337L may be formed on the interlayer insulator 420 and the preliminary contact 25. The bit-line layer 332L may include metal. The bit-line capping layer 337L may include silicon nitride.

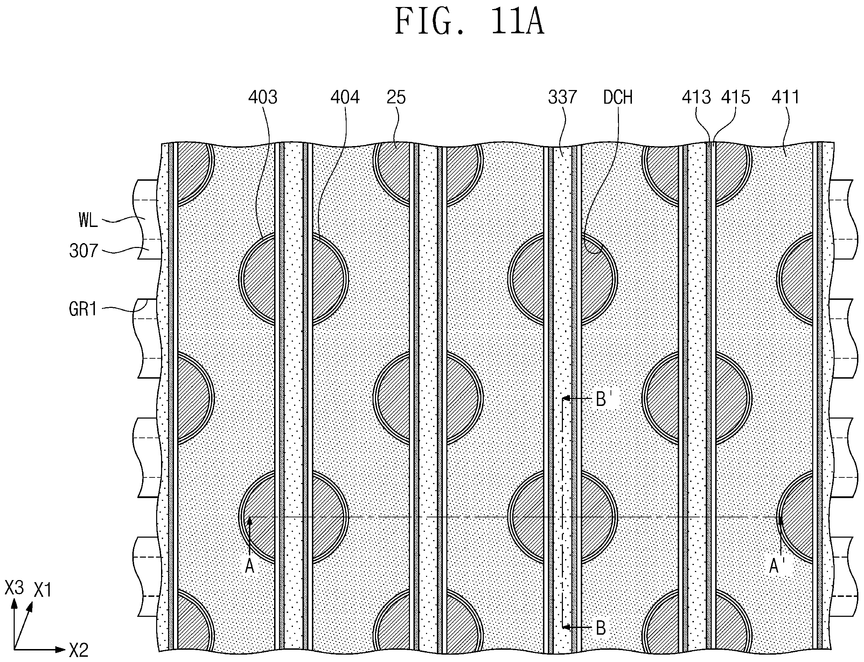

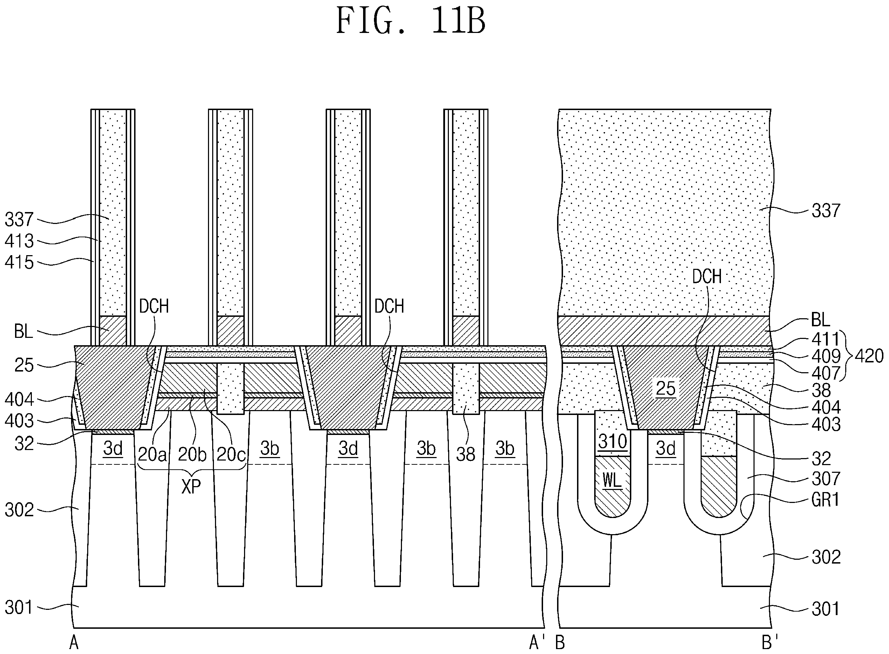

Referring to FIGS. 11A and 11B, the bit-line capping layer 337L and the bit-line layer 332L may be sequentially etched to expose the top surfaces of the interlayer insulator 420, the preliminary contact 25, the first lower contact dielectric pattern 403, and the second lower contact dielectric pattern 404 and at the same time to form a bit-line capping pattern 337 and a bit line BL. A first protective spacer 413 and a second protective spacer 415 may be formed to sequentially cover a sidewall of the bit-line capping pattern 337 and a sidewall of the bit line BL. One of the first and second protective spacers 413 and 415 may include a material having an etch selectivity with respect to the other of the first and second protective spacers 413 and 415. The first protective spacer 413 may include, e.g., the same material as that of the second lower contact dielectric pattern 404. The second protective spacer 415 may include, e.g., the same material as that of the first lower contact dielectric pattern 403. The first protective spacer 413 may include a material having an etch selectivity with respect to the bit-line capping pattern 337 and the third interlayer dielectric layer 411. The first protective spacer 413 may be formed of, e.g., SiOC. The second protective spacer 415 may be formed of, e.g., silicon oxide.

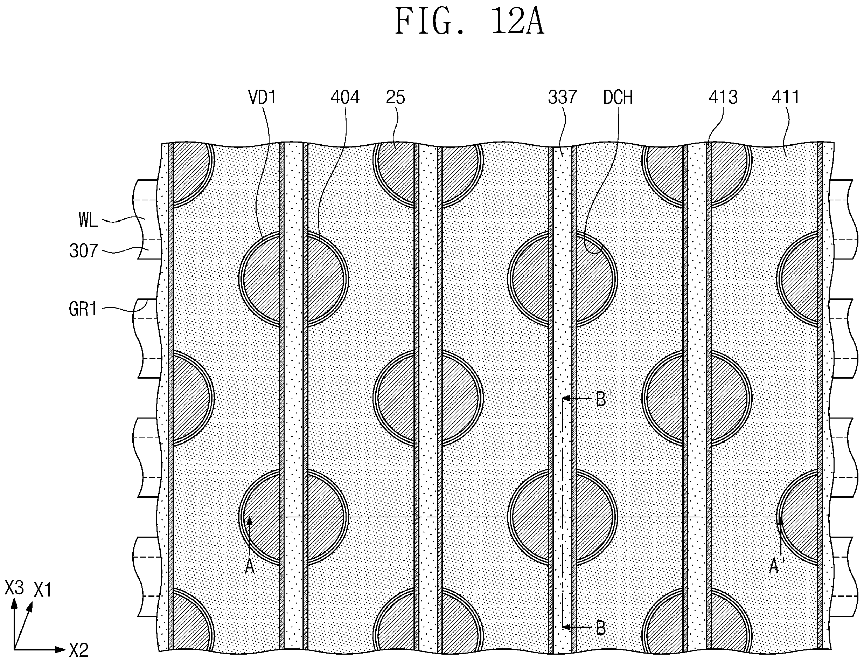

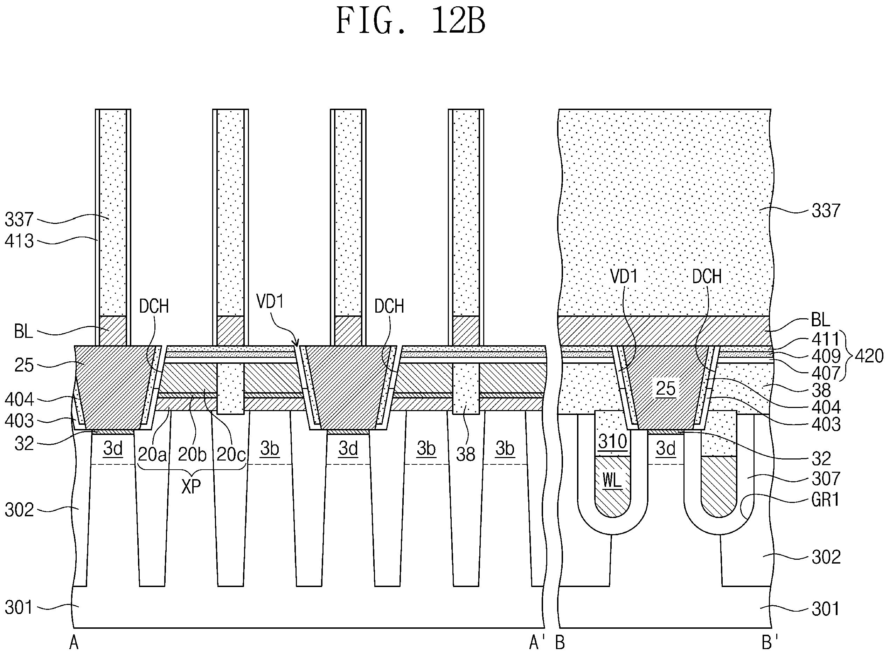

Referring to FIGS. 12A and 12B, the first lower contact dielectric pattern 403 may be partially removed to form an empty space VD1 between the second lower contact dielectric pattern 404 and the storage node pad XP. An isotropic etching process may be performed to partially remove the first lower contact dielectric pattern 403. When the first lower contact dielectric pattern 403 includes silicon oxide, the isotropic etching process may be performed using, e.g., hydrofluoric acid. The isotropic etching process may also remove the second protective spacer 415 formed of the same material as that of the first lower contact dielectric pattern 403. Therefore, a sidewall of the first protective spacer 413 may be exposed. In this step, the first protective spacer 413 may protect the bit-line capping pattern 337 and the bit line BL. The empty space VD1 may also be formed beneath the bit line BL.

If the first lower contact dielectric pattern 403 were not partially, but rather completely, removed in the isotropic etching process, the device isolation pattern 302 could also be removed beneath the first lower contact dielectric pattern 403. Accordingly, the possibility of occurrence of failure may become high. According to the embodiments, the first lower contact dielectric pattern 403 may only be partially removed, and the device isolation pattern 302 may be protected.

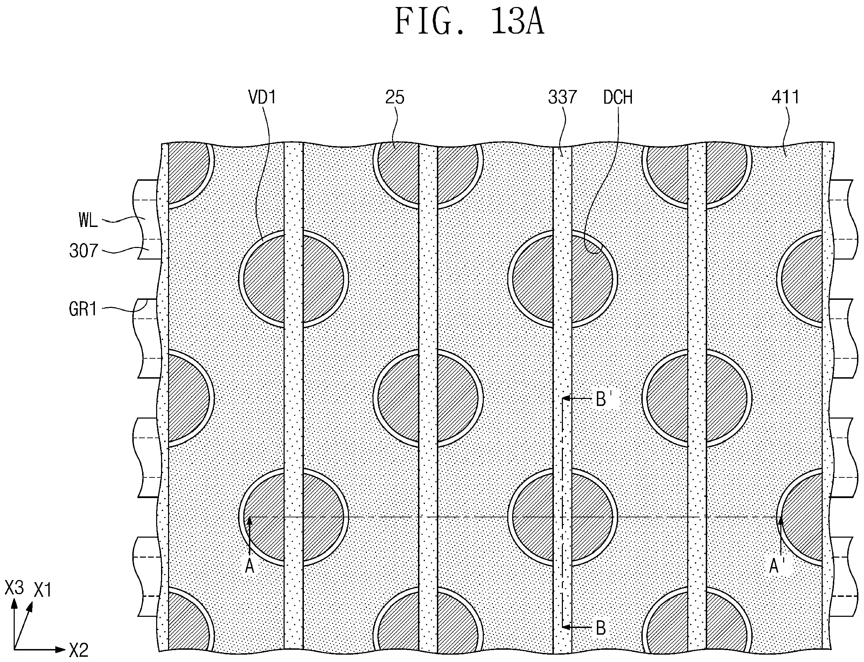

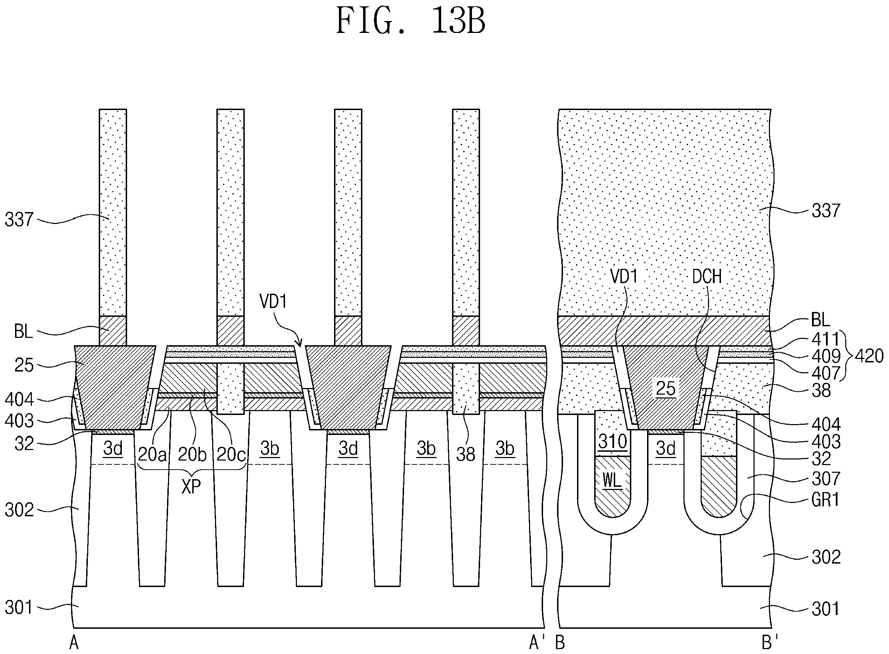

Referring to FIGS. 13A and 13B, the second lower contact dielectric pattern 404 may be partially removed to expand the empty space VD1. Therefore, the empty space VD1 may also expose a sidewall of the preliminary contact 25. An isotropic etching process may be performed to partially remove the second lower contact dielectric pattern 404. When the second lower contact dielectric pattern 404 includes SiOC, the isotropic etching process may be performed using, e.g., H₂N₂ and hydrofluoric acid. In this step, the isotropic etching process may also remove the first protective spacer 413 formed of the same material as that of the second lower contact dielectric pattern 404. Therefore, the sidewall of the bit line BL may be exposed and the sidewall of the bit-line capping pattern 337 may be exposed. The first protective spacer 413 may protect the bit-line capping pattern 337 and the bit line BL during the etching process.

If the second lower contact dielectric pattern 404 were not just partially removed, but rather completely removed, in the isotropic etching process, the device isolation pattern 302 could also be removed. Accordingly, the possibility of occurrence of failure may become high. According to the embodiments, the second lower contact dielectric pattern 404 may only be partially removed, the device isolation pattern 302 may be protected.

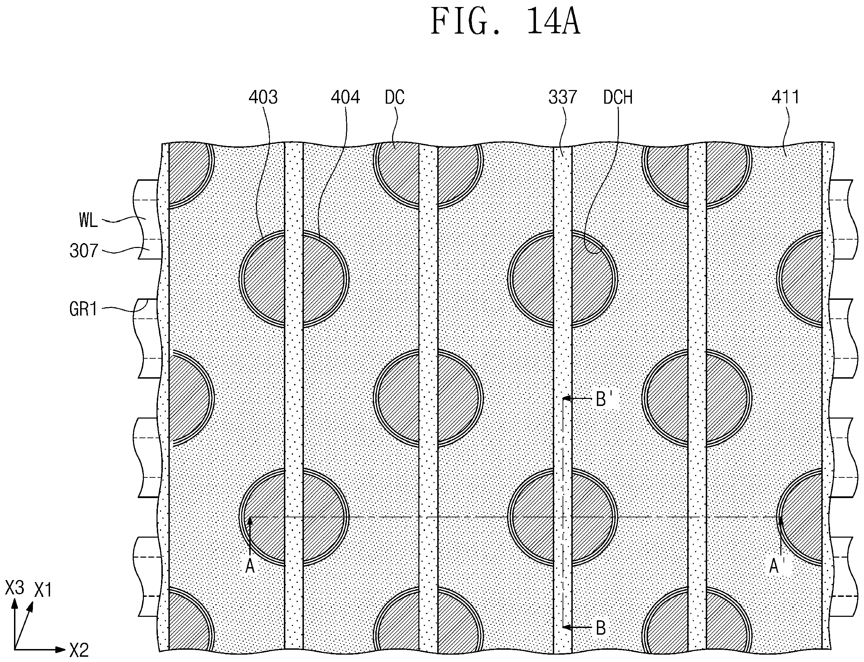

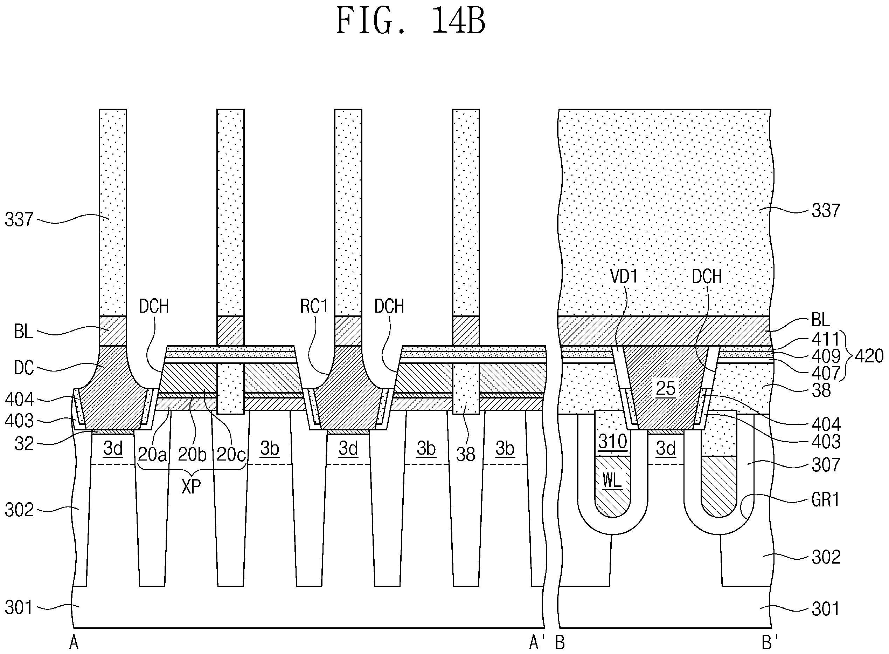

Referring to FIGS. 14A and 14B, an etching process may be performed in which the bit-line capping pattern 337 is used as an etching mask to etch the preliminary contact 25 to form a bit-line contact DC. In this case, an etchant to etch the preliminary contact 25 may be favorably introduced through the empty space VD1 into the contact hole DCH, and thus the preliminary contact 25 may be easily etched. The etching process may form a recess RC1 on the bit-line contact DC. The storage node pad XP and the interlayer insulator 420 may be exposed on an inner sidewall of the contact hole DCH.

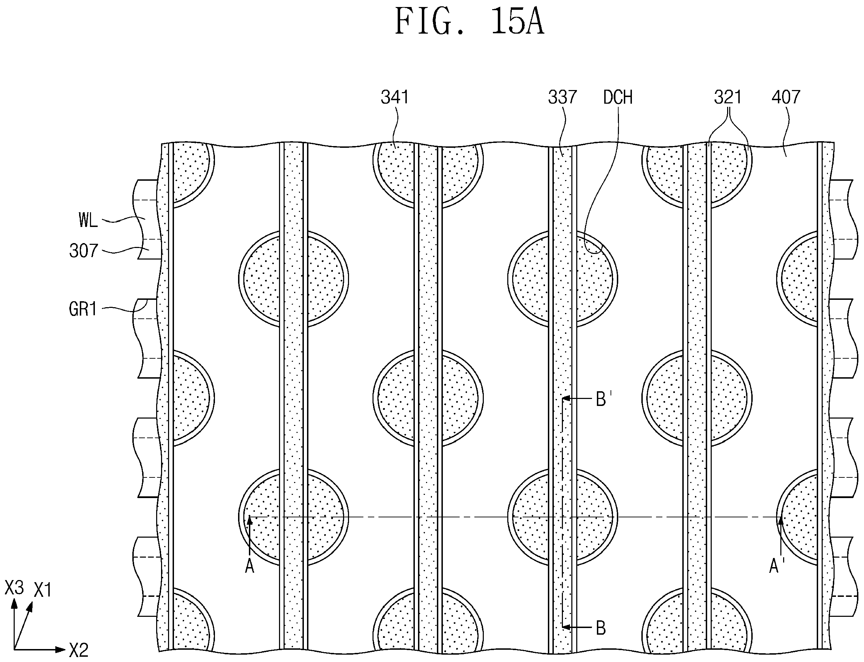

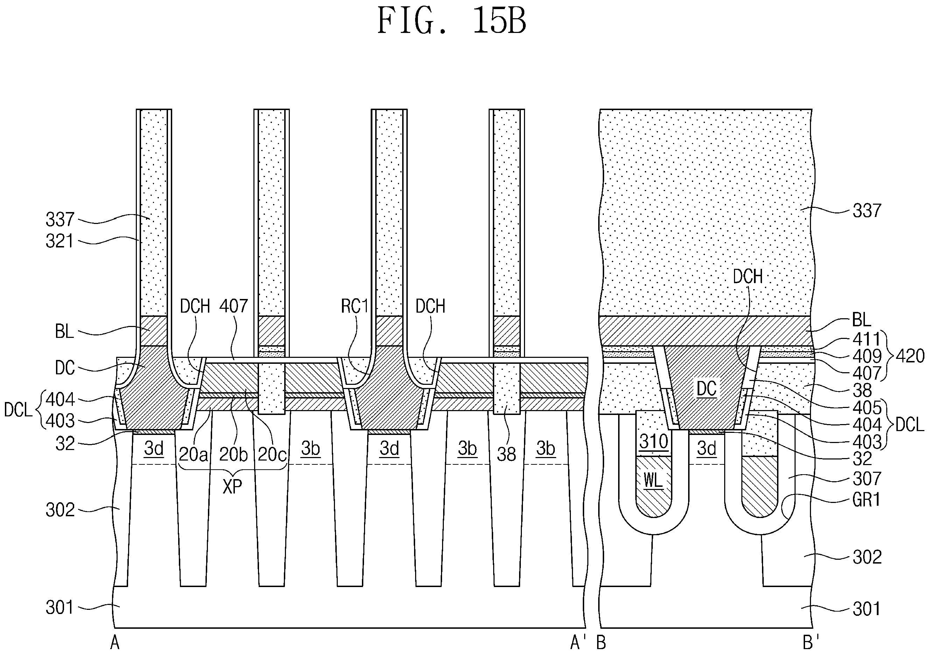

Referring to FIGS. 15A and 15B, the second and third interlayer dielectric layers 409 and 411 on a side of the bit line BL may be etched to expose a top surface of the first interlayer dielectric layer 407. A separate process may be employed to etch the second and third interlayer dielectric layers 409 and 411. In an implementation, the etching of the second and third interlayer dielectric layers 409 and 411 may be performed simultaneously with the etching of the preliminary contact 25 shown in FIGS. 14A and 14B. In an implementation, when the preliminary contact 25 is etched, the second and third interlayer dielectric layers 409 and 411 may also be etched.

A first spacer layer may be conformally formed on an entire surface of the substrate 301. The first spacer layer may fill the empty space VD1, which is seen in cross-sectional view of FIG. 14B, beneath the bit line BL to form an upper contact dielectric pattern 405. Therefore, a contact insulator DCL may be formed which includes the first lower contact dielectric pattern 403, the second lower contact dielectric pattern 404, and the upper contact dielectric pattern 405.

A buried dielectric layer may be stacked to fill the recess RC1. The buried dielectric layer may undergo an etch-back process to form a buried dielectric pattern 341 in the recess RC1. The first spacer layer may undergo an isotropic etching process to form a first spacer 321 that covers the sidewall of the bit line BL.

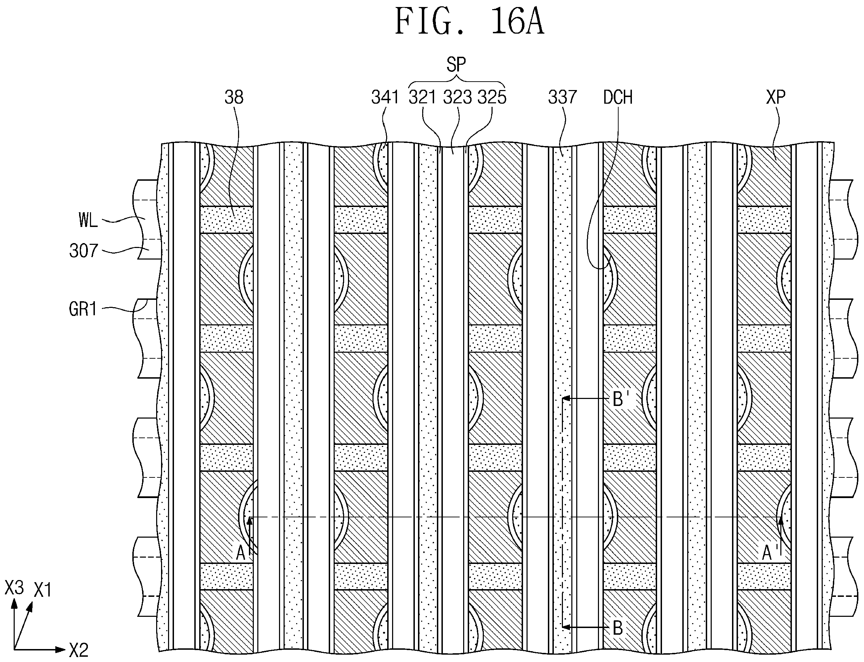

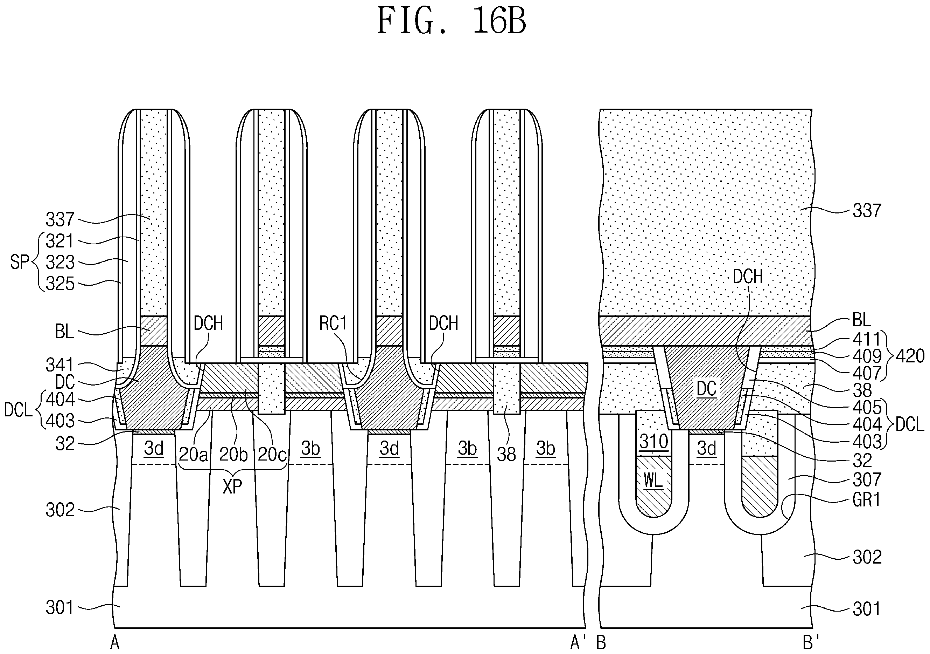

Referring to FIGS. 16A and 16B, a second spacer layer may be conformally stacked on the entire surface of the substrate 301, and the second spacer layer may then be anisotropically etched to form a second spacer 323 that covers a sidewall of the first spacer 321. In this step, the first interlayer dielectric layer 407 may also be etched to expose top surfaces of the storage node pads XP. In addition, the buried dielectric pattern 341 and the first spacer 321 may also be partially exposed. A third spacer layer may be conformally stacked on the entire surface of the substrate 301, and the third spacer layer may then be etched-back to form a third spacer 325 that covers a sidewall of the second spacer 323. Therefore, a bit-line spacer SP may be formed.

Referring to FIGS. 17A and 17B, node separation patterns 44 may be formed between the bit lines BL. The node separation patterns 44 may be spaced apart from each other along the third direction X3. The node separation patterns 44 may include, e.g., silicon oxide or silicon nitride. The node separation patterns 44 may overlap the pad separation pattern 38. Storage node contact holes BCH may be formed between the node separation patterns 44 and between the bit lines BL. An upper portion of the bit-line spacer SP may also be partially etched while the storage node contact hole BCH is formed. In addition, upper portions of the storage node pads XP may also be partially etched.

Subsequently, referring to FIGS. 1A and 1B, a contact diffusion barrier layer may be conformally formed on the entire surface of the substrate 301, and on the contact diffusion barrier layer, a contact metal layer may be formed to fill the storage node contact hole BCH. The contact diffusion barrier layer and the contact metal layer may each include a metal, and may be formed by a process (e.g., deposition process) performed at a lower temperature (e.g., hundreds of degrees Celsius or from about 300 °C to about 400 °C) than that (e.g., about 1,000 °C) of an annealing process.

A chemical mechanical polishing (CMP) process may be performed to expose a top surface of the bit-line capping pattern 337 and at the same time to form a contact diffusion barrier pattern 311 and a contact metal pattern 313. A portion of the contact diffusion barrier layer may be formed into the contact diffusion barrier pattern 311. A portion of the contact metal layer may be formed into the contact metal pattern 313. The contact diffusion barrier pattern 311 and the contact metal pattern 313 may constitute a storage node contact BC.

A conductive layer may be stacked on the storage node contact BC and the bit-line capping patterns 337, and then the conductive layer may be etched to form landing pads LP and also to form trenches between the landing pads LP. The trenches may be filled with a dielectric layer, and then an etch-back process or a chemical mechanical polishing (CMP) process may be performed to form landing pad separation patterns LPS.

In a method of fabricating a semiconductor memory device according to some embodiments, the pad layer 20 may be formed flat without any step difference, defects may be prevented in an etching process for forming the storage node pad XP. The first and second lower contact dielectric patterns 403 and 404 may be partially removed to protect the device isolation pattern 302. Therefore, process defects may be reduced. The pad metal layer 20c may be on the storage node pad XP, and the bit-line contact DC may be formed of a metal. It may not be required to form an ohmic layer in the bit-line contact DC, and thus fabrication process may be simplified. Because the bit-line contact DC excludes polysilicon, it may be possible to omit a high-temperature annealing process for crystallization of amorphous polysilicon. As a result, a manufacturing yield may increase.

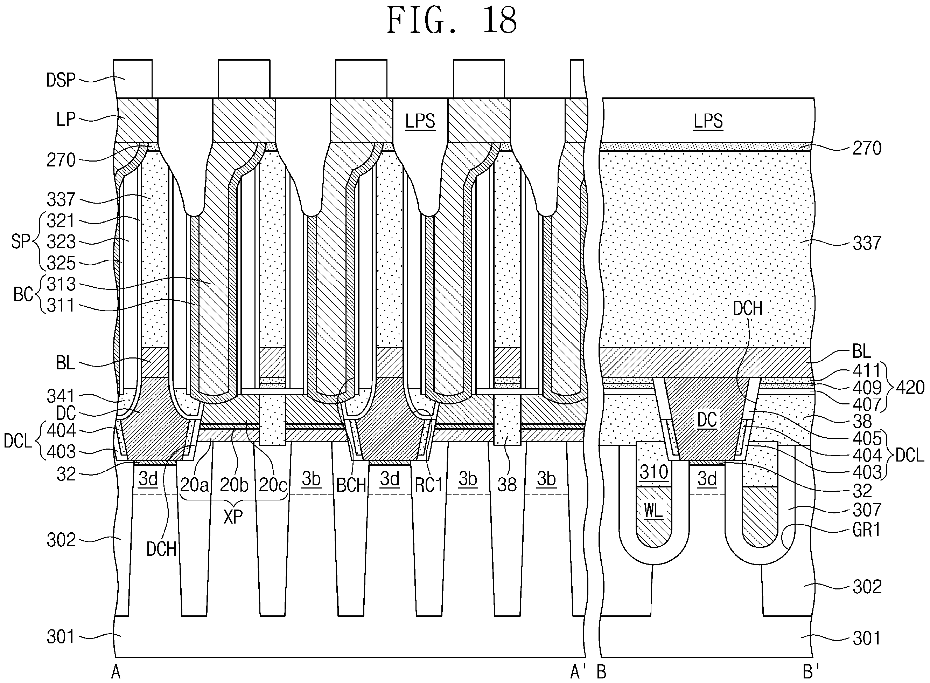

FIG. 18 illustrates a cross-sectional view taken along lines A-A' and B-B' of FIG. 1A.

Referring to FIG. 18, a semiconductor memory device according to the present embodiment may include a reinforcement capping pattern 270 on the bit-line capping pattern 337. The reinforcement capping pattern 270 may include, e.g., a metal oxide. The reinforcement capping pattern 270 may be formed by forming a reinforcement capping layer on the bit-line capping layer 337L in the step of FIG. 10B, and then patterning the reinforcement capping layer in the step of FIG. 11B. The reinforcement capping pattern 270 may be used as an etching mask to etch the preliminary contact 25 to form the bit-line contact DC of FIG. 14B. In an implementation, the preliminary contact 25 may include a metal, and the bit-line capping pattern 337 formed of silicon nitride may be difficult to endure the etching process for etching the metal. In an implementation, the reinforcement capping pattern 270 may be formed on the bit-line capping pattern 337 in order to prevent damage/loss of the bit-line capping pattern 337. Other configurations and processes may be identical or similar to those discussed above.

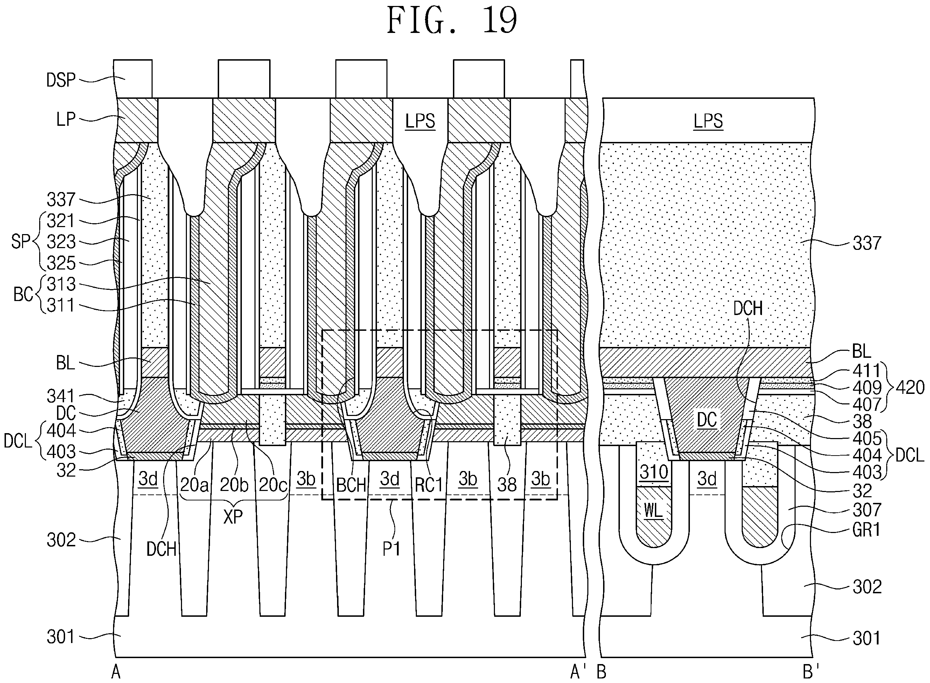

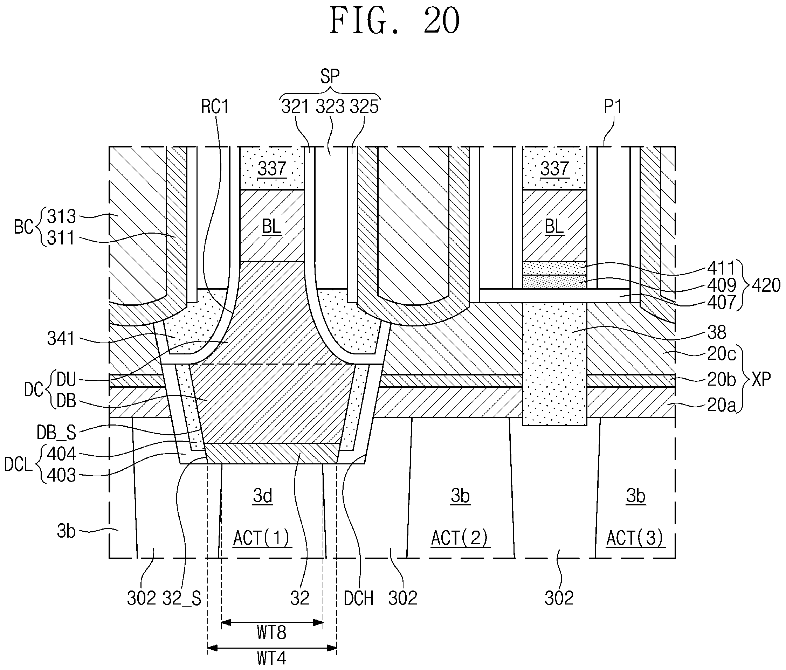

FIG. 19 illustrates a cross-sectional view taken along lines A-A' and B-B' of FIG. 1A. FIG. 20 illustrates an enlarged view showing section PI of FIG. 19.

Referring to FIGS. 19 and 20, a semiconductor memory device according to the present embodiment may be configured such that a sidewall 32_S of the contact ohmic layer 32 is aligned (e.g., coplanar) with a sidewall DB_S of the lower part DB of the bit-line contact DC. A bottom surface of the contact ohmic layer 32 may be coplanar with that of the contact insulator DCL. The contact ohmic layer 32 may have a fourth width WT4 at the bottom surface thereof. The first active section ACT(1) beneath the contact ohmic layer 32 may have an eighth width WT8. The eighth width WT8 may be less than the fourth width WT4. The semiconductor memory device according to the present embodiment may be configured such that the fourth width WT4 at the bottom surface of the contact ohmic layer 32 may be greater than the eighth width WT8 of the first active section ACT(1) to help decrease a contact resistance between the bit-line contact DC and the substrate 301. The contact ohmic layer 32 may be in contact with the first lower contact dielectric pattern 403 or the second lower contact dielectric pattern 404. Other structural features may be identical or similar to those discussed above.

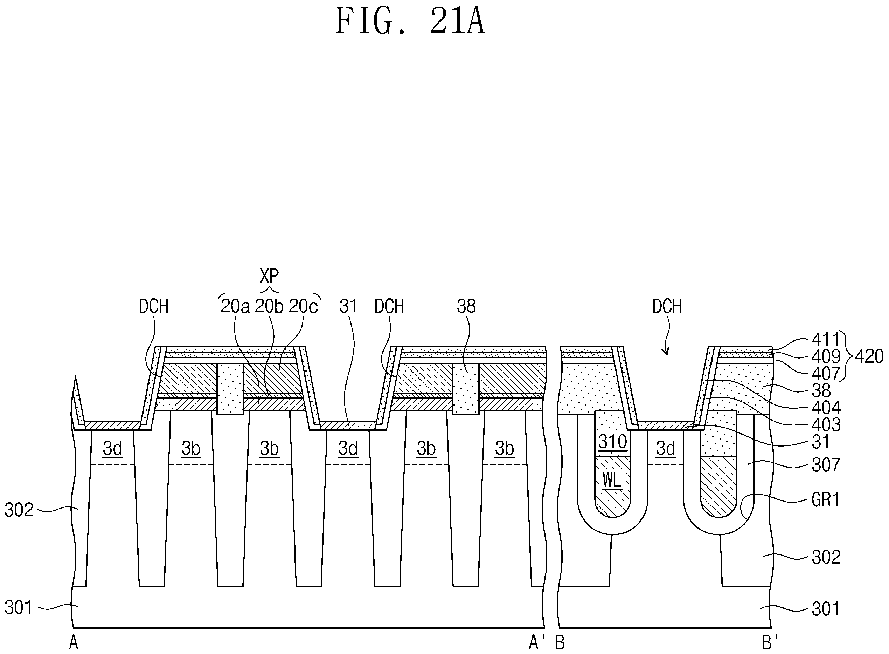

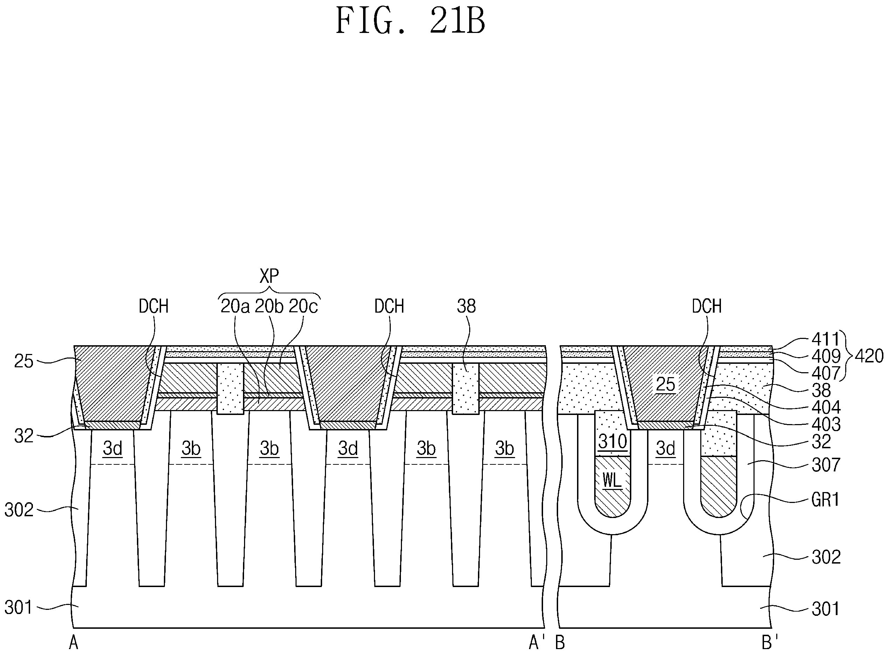

FIGS. 21A and 21B illustrate cross-sectional views of stages in a method of fabricating the semiconductor memory device shown in FIG. 19.

Referring to FIG. 21A, in the step of FIGS. 8A and 8B, a silicon pattern 31 may be formed in a lower portion of the contact hole DCH. The silicon pattern 31 may include monocrystalline silicon or polycrystalline silicon. The silicon pattern 31 may be formed by stacking a silicon layer and then performing an etch-back process on the silicon layer, or a selective epitaxial growth (SEG) process may be performed in which the silicon pattern 31 is grown from the substrate 301 or from a bottom surface of the contact hole DCH. The silicon pattern 31 may expose a sidewall of the second lower contact dielectric pattern 404.

Referring to FIG. 21B, a metal layer may be formed on the entire surface of the substrate 301 before the silicon pattern 31 is formed, and thus the contact hole DCH may be filled with the metal layer. As the metal layer is formed, the metal layer may react with the silicon pattern 31. Therefore, the silicon pattern 31 may be converted into the contact ohmic layer 32 formed of metal silicide. After the metal layer is formed, a chemical mechanical polishing process or an etch-back process may be performed to expose a top surface of the interlayer insulator 420 and at the same time to form a preliminary contact 25 in the contact hole DCH. In this step, there may be exposed top surfaces of the first and second lower contact dielectric patterns 403 and 404. Subsequent processes discussed with reference to FIGS. 10A to 17B may be performed.

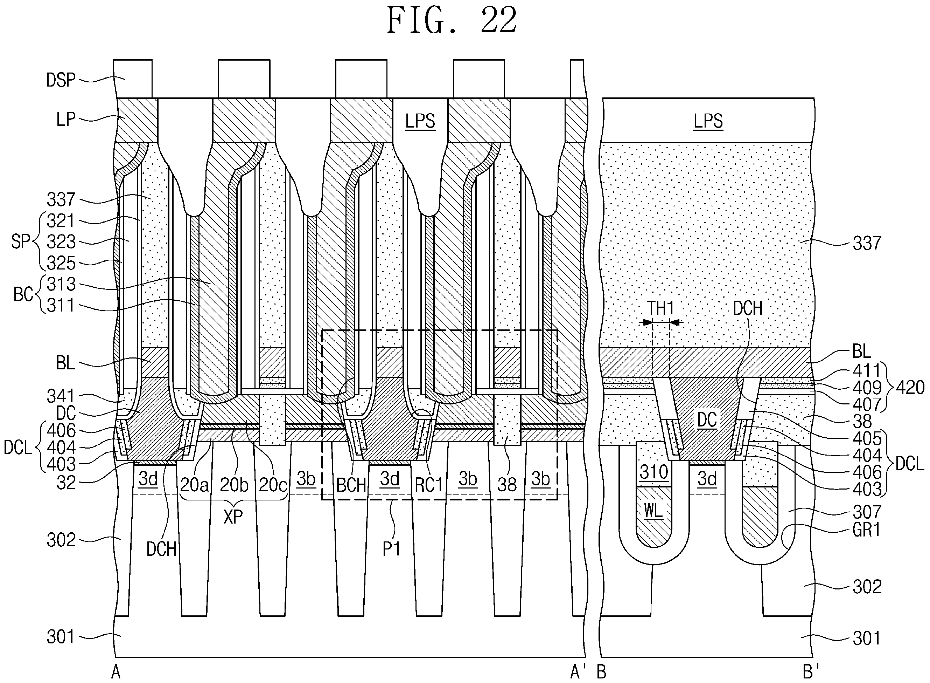

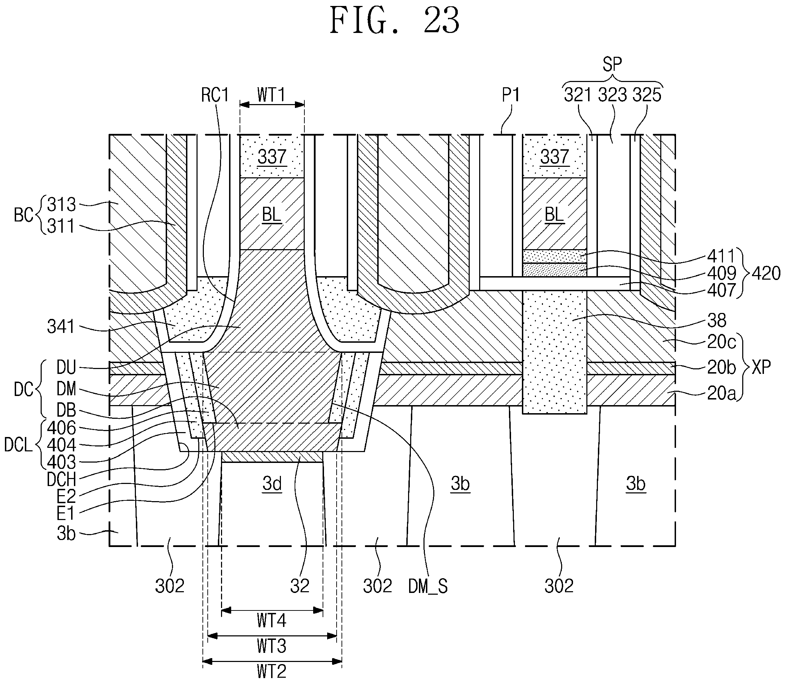

FIG. 22 illustrates a cross-sectional view taken along lines A-A' and B-B' of FIG. 1A. FIG. 23 illustrates an enlarged view showing section PI of FIG. 22.

Referring to FIGS. 22 and 23, a semiconductor memory device according to the present embodiment may be configured such that a third lower contact dielectric pattern 406 may further be included in the contact insulator DCL in contact with a sidewall of the bit-line contact DC. The third lower contact dielectric pattern 406 may be positioned beneath the upper contact dielectric pattern 405. The third lower contact dielectric pattern 406 may be in contact with a sidewall of the second lower contact dielectric pattern 404 and may be spaced apart from the first lower contact dielectric pattern 403. The third lower contact dielectric pattern 406 may include a material the same as or different from that of the second lower contact dielectric pattern 404. The third lower contact dielectric pattern 406 may have a bottom end E1 higher than a bottom end E2 of the second lower contact dielectric pattern 404. The upper contact dielectric pattern 405 may have a thickness TH1 that is the same as a sum of thicknesses of the first, second, and third lower contact dielectric patterns 403, 404, and 406. The thickness TH1 of the upper contact dielectric pattern 405 may range, e.g., from about 4 nm to about 10 nm.

The bit-line contact DC may include an upper part DU, a lower part DB, and an intermediate part DM between the upper and lower parts DU and DB. No interface may be present between the lower, intermediate, and upper parts DB, DM, and DU of the bit-line contact DC. The bit-line contact DC may have a first width WT1 at a top surface thereof. The upper part DU of the bit-line contact DC may have a width that increases in a downward direction. The bit-line contact DC may have a recess RC1 on a sidewall of the upper part DU.

The intermediate part DM of the bit-line contact DC may have a width that decreases in a downward direction. The bit-line contact DC may have a second width WT2 at a portion where the upper part DU and the intermediate part DM meet each other. The second width WT2 may be greater than the first width WT1.

In an implementation, the lower part DB of the bit-line contact DC may have an edge that laterally protrudes from a sidewall DM_S of the intermediate part DM of the bit-line contact DC. The lower part DB of the bit-line contact DC may have a width that decreases in a downward direction. The bit-line contact DC may have a third width WT3 at a bottom surface thereof. The second width WT2 may be greater than the third width WT3. Other structural features may be identical or similar to those discussed above.

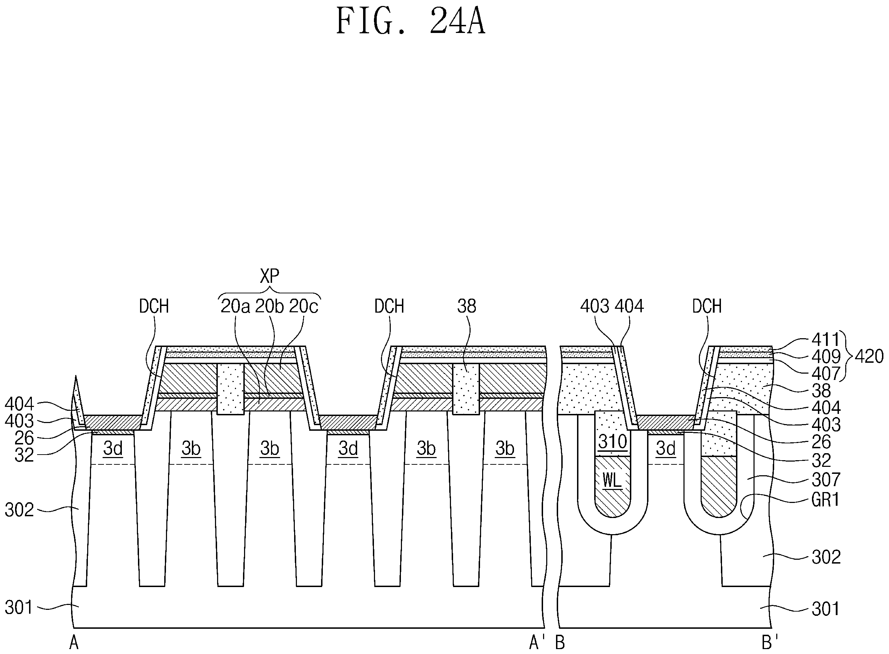

FIGS. 24A to 24E illustrate cross-sectional views of stages in a method of fabricating the semiconductor memory device shown in FIG. 22.

Referring to FIG. 24A, in the step of FIGS. 8A and 8B, a lower metal pattern 26 may be formed in a lower portion of the contact hole DCH. The lower metal pattern 26 may be formed of the same material as that of a bit-line contact DC which will be discussed below. The lower metal pattern 26 may be formed by forming a metal layer and then performing an etch-back process on the metal layer. The lower metal pattern 26 may expose a sidewall of the second lower contact dielectric pattern 404. When the metal layer is stacked to form the lower metal pattern 26, the metal layer and a surface of the substrate 301 may react with each other to form a contact ohmic layer 32.

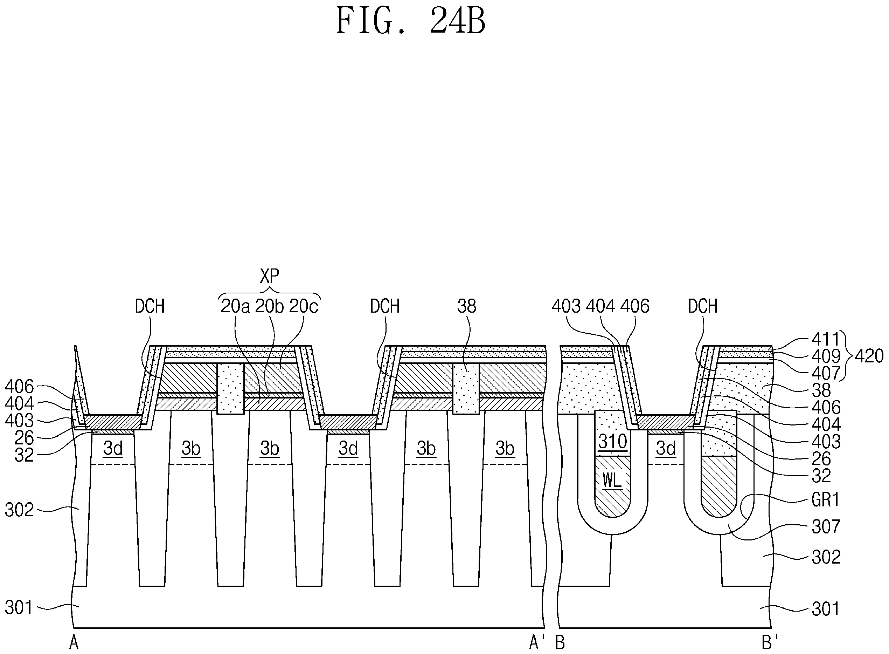

Referring to FIG. 24B, a third lower contact dielectric pattern 406 may be formed to cover the sidewall of the second lower contact dielectric pattern 404. The third lower contact dielectric pattern 406 may be in contact with a top surface of the lower metal pattern 26. The third lower contact dielectric pattern 406 may be formed of, e.g., a material the same as or different from that of the second lower contact dielectric pattern 404.

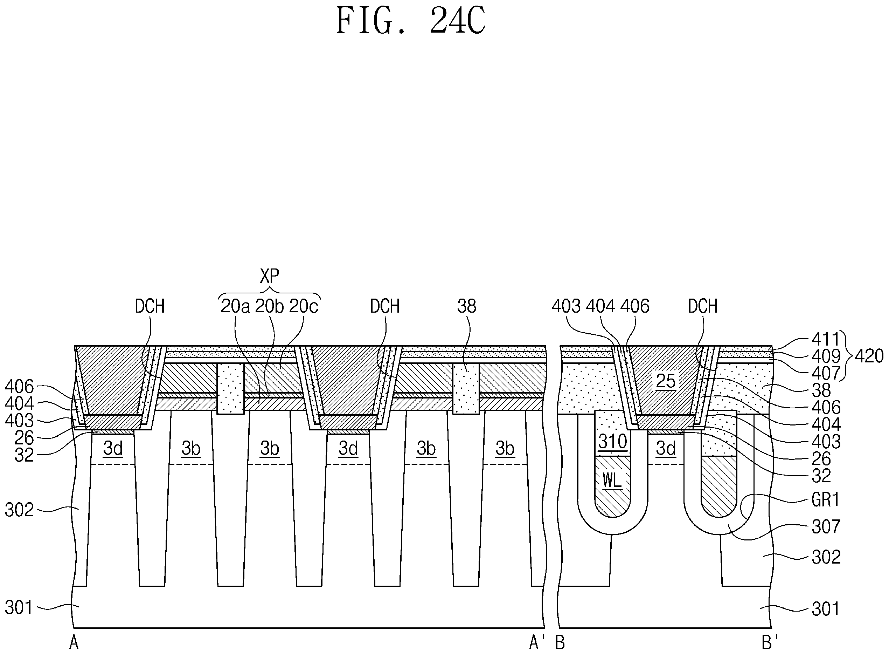

Referring to FIG. 24C, a metal layer may be formed on the entire surface of the substrate 301, thereby filling the contact hole DCH. After the metal layer is stacked, a chemical mechanical polishing process or an etch-back process may be performed to expose a top surface of the interlayer insulator 420 and at the same time to form a preliminary contact 25 in the contact hole DCH. In this step, there may be exposed top surfaces of the first, second, and third lower contact dielectric patterns 403, 404, and 406. When the preliminary contact 25 and the lower metal pattern 26 are formed of the same material, an invisible interface may be between the preliminary contact 25 and the lower metal pattern 26.

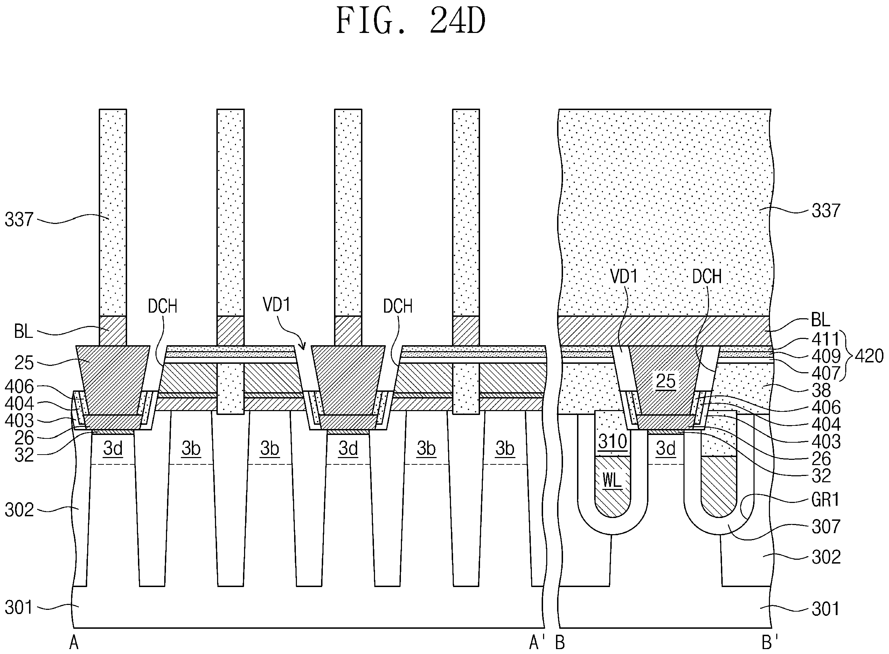

Processes discussed with reference to FIGS. 10A to 13B may be performed. Referring to FIG. 24D, the second lower contact dielectric pattern 404 may be partially removed, and then the third lower contact dielectric pattern 406 may be partially removed to expand the empty space VD1.

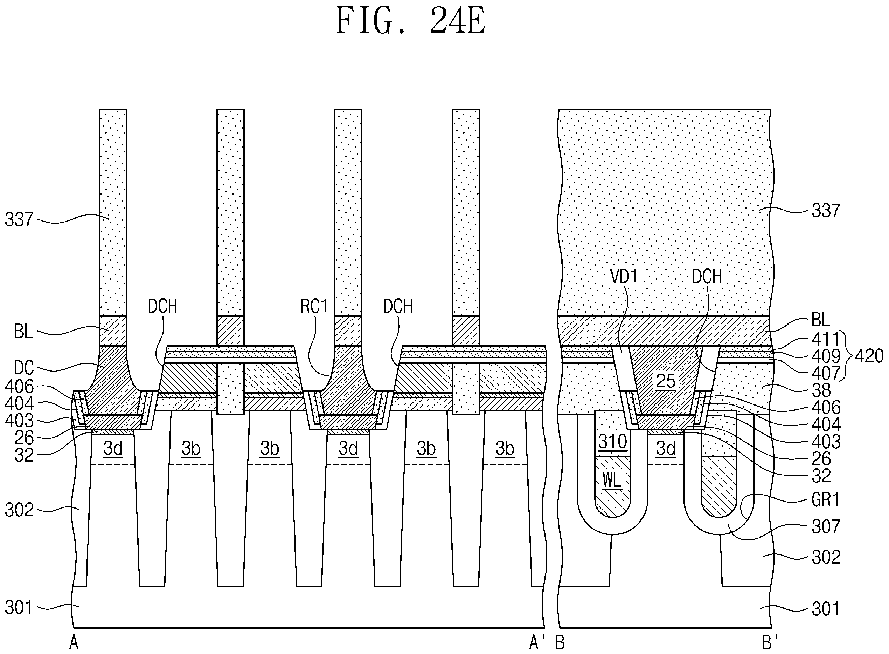

Referring to FIG. 24E, the preliminary contact 25 on a side of the bit line BL may be etched to form a bit-line contact DC. The bit-line contact DC may include the lower metal pattern 26 and a portion of the preliminary contact 25. Because the third lower contact dielectric pattern 406 is partially removed to expand the empty space VD1, the preliminary contact 25 may be easily etched. Subsequently, the processes discussed with reference to FIGS. 15A to 17B may be performed. When a first spacer layer is formed to form the first spacer 321, a portion of the first spacer layer may fill the empty space VD1 to form the upper contact dielectric pattern 405 of FIG. 22.

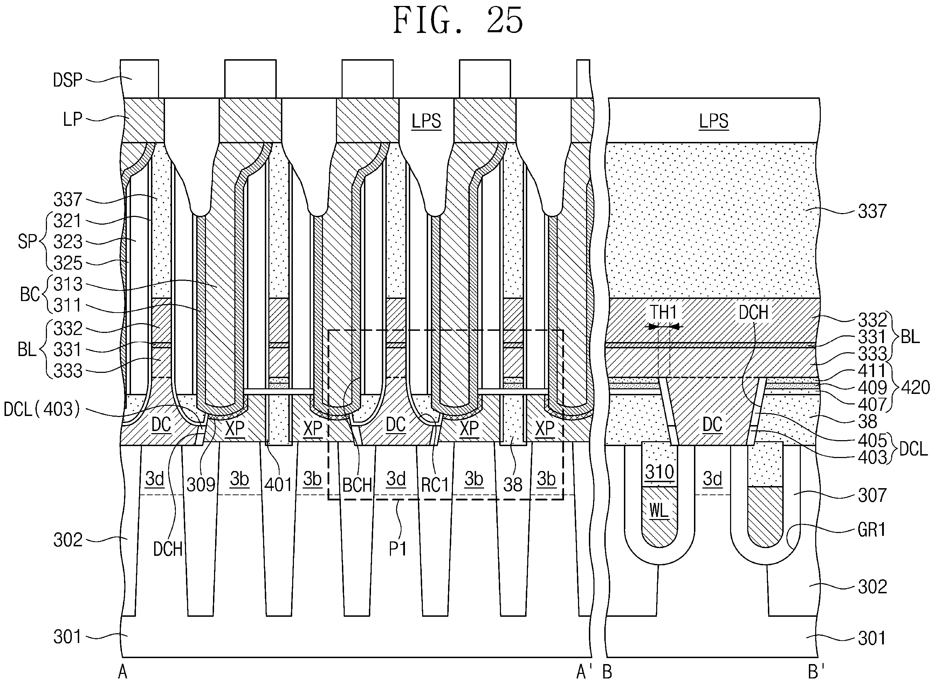

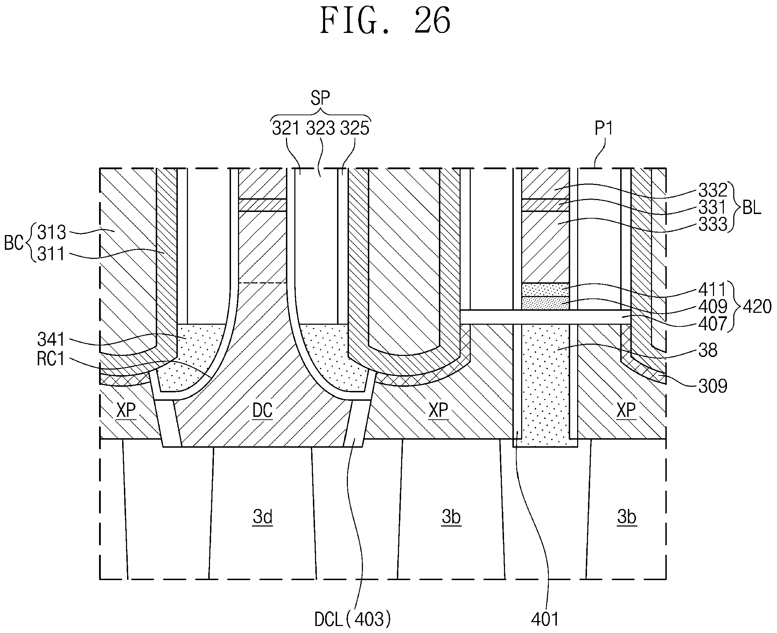

FIG. 25 illustrates a cross-sectional view taken along lines A-A' and B-B' of FIG. 1A. FIG. 26 illustrates an enlarged view showing section PI of FIG. 25.

Referring to FIGS. 25 and 26, a semiconductor memory device according to the present embodiment may be configured such that the bit line BL may include a bit-line polysilicon pattern 333, a bit-line diffusion barrier pattern 331, and a bit-line wire pattern 332 that are sequentially stacked. A portion of the bit-line polysilicon pattern 333 may be introduced into the contact hole DCH, thereby constituting the bit-line contact DC. No interface may be between the bit-line contact DC and the bit-line polysilicon pattern 333. The bit-line contact DC and the bit-line polysilicon pattern 333 may be formed of impurity-doped polysilicon. The bit-line diffusion barrier pattern 331 may be formed of a metal nitride layer. The bit-line diffusion barrier pattern 331 may include, e.g., titanium, titanium nitride (TiN), titanium silicon nitride (TiSiN), tantalum, tantalum nitride, or tungsten nitride. The bit-line wire pattern 332 may be formed of, e.g., titanium, tantalum, ruthenium, molybdenum, tantalum nitride, tungsten, aluminum, or copper.

In an implementation, the contact ohmic layer 32 of FIG. 1B may be absent between the bit-line contact DC and the substrate 301. The contact insulator DCL to cover a sidewall of the bit-line contact DC may include a lower contact dielectric pattern 403. Below the bit line BL, the contact insulator DCL may include the upper contact dielectric pattern 405 on the lower contact dielectric pattern 403. The upper contact dielectric pattern 405 may have a thickness TH1 the same as a thickness of the lower contact dielectric pattern 403. The thickness TH1 of the upper contact dielectric pattern 405 may range, e.g., from about 4 nm to about 10 nm.

In an implementation, the storage node pad XP may be formed of impurity-doped polysilicon. The storage node pad XP may exclude, e.g., may be essentially free of, metal. The pad separation pattern 38 may be between the storage node pads XP. A subsidiary dielectric pattern 401 may be between the pad separation pattern 38 and the storage node pad XP. The subsidiary dielectric pattern 401 may be formed of, e.g., silicon oxide. A pad ohmic layer 309 may be between the storage node pad XP and the storage node contact BC. The pad ohmic layer 309 may be formed of metal silicide. The metal silicide may be, e.g., cobalt silicide or titanium silicide. The pad ohmic layer 309 may have a rounded bottom surface. Other structural features may be identical or similar to those discussed above.

In an implementation, the bottom surface of the pad ohmic layer 309 may be rounded, and a contact area may be increased to decrease an electrical resistance. Therefore, it may be possible to improve tRDL defects. In addition, the storage node contact BC adjacent to the storage node pad XP may exclude polysilicon and include metal whose electrical resistance is low, and accordingly tRDL defects may be effectively improved.

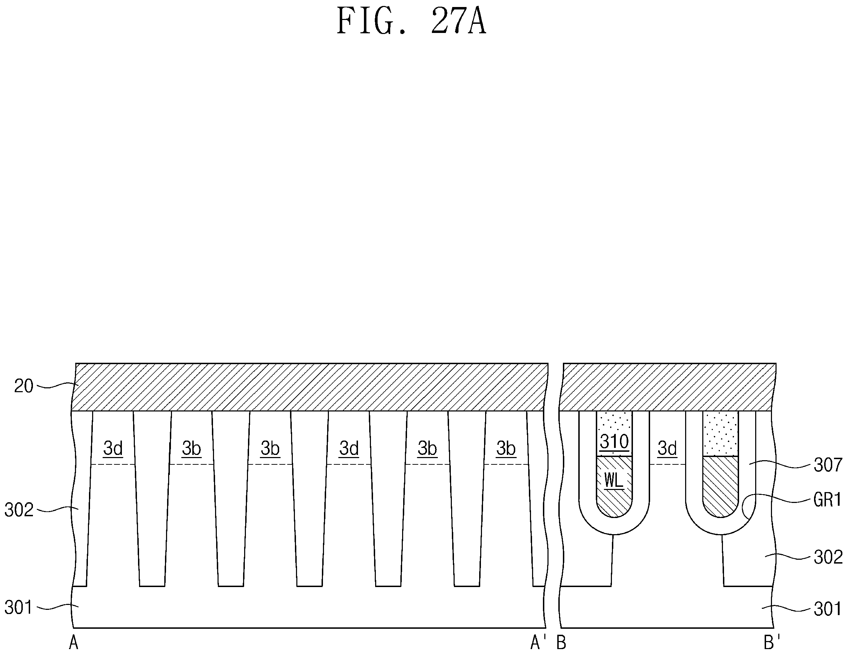

FIGS. 27A to 27D illustrate cross-sectional views of stages in a method of fabricating the semiconductor memory device shown in FIG. 25.

Referring to FIG. 27A, a pad layer 20 may be formed on the entire surface of the substrate 301 in a state of FIGS. 3A and 3B. The pad layer 20 may be formed of impurity-doped polysilicon.

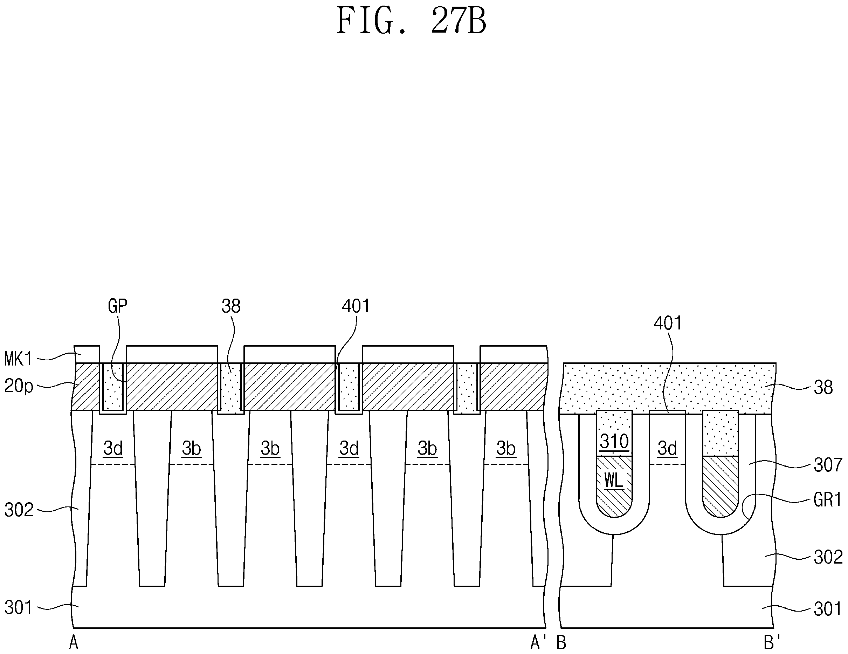

Referring to FIG. 27B, a mask pattern MK1 may be formed on the pad layer 20. The mask pattern MK1 may be used as an etching mask to etch the pad layer 20 to form preliminary pads 20p. A subsidiary dielectric pattern 401 may be formed on sidewalls of the preliminary pads 20p. A pad separation pattern 38 may be formed in a gap GP between the preliminary pads 20p.

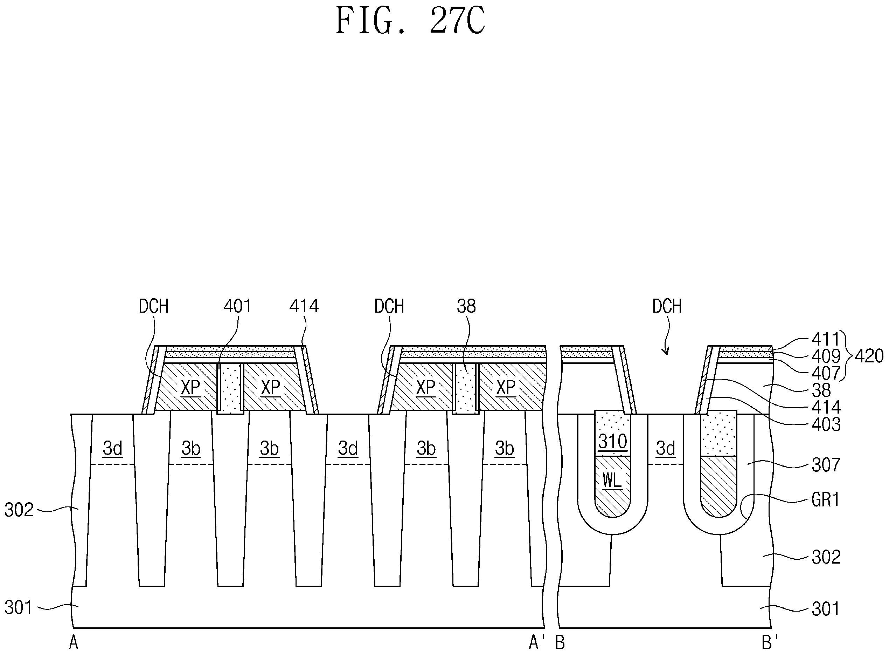

Referring to FIG. 27C, the mask pattern MK1 may be removed. An interlayer insulator 420 may be formed on the preliminary pads 20p and the pad separation pattern 38. The pad separation pattern 38 and the interlayer insulator 420 on the first impurity regions 3d may be etched to form contact holes DCH that expose the first impurity regions 3d. In this step, the preliminary pads 20p adjacent to the pad separation pattern 38 may also be partially etched to form storage node pads XP.

A lower contact dielectric pattern 403 and a lower protective spacer 414 may be formed to sequentially cover inner walls of the contact holes DCH. The lower contact dielectric pattern 403 may be formed of, e.g., silicon oxide. The lower protective spacer 414 may be formed of, e.g., polysilicon. A cleaning process may be performed after the formation of the lower contact dielectric pattern 403 and the lower protective spacer 414. The lower protective spacer 414 may help prevent the loss of the lower contact dielectric pattern 403 in the cleaning process.

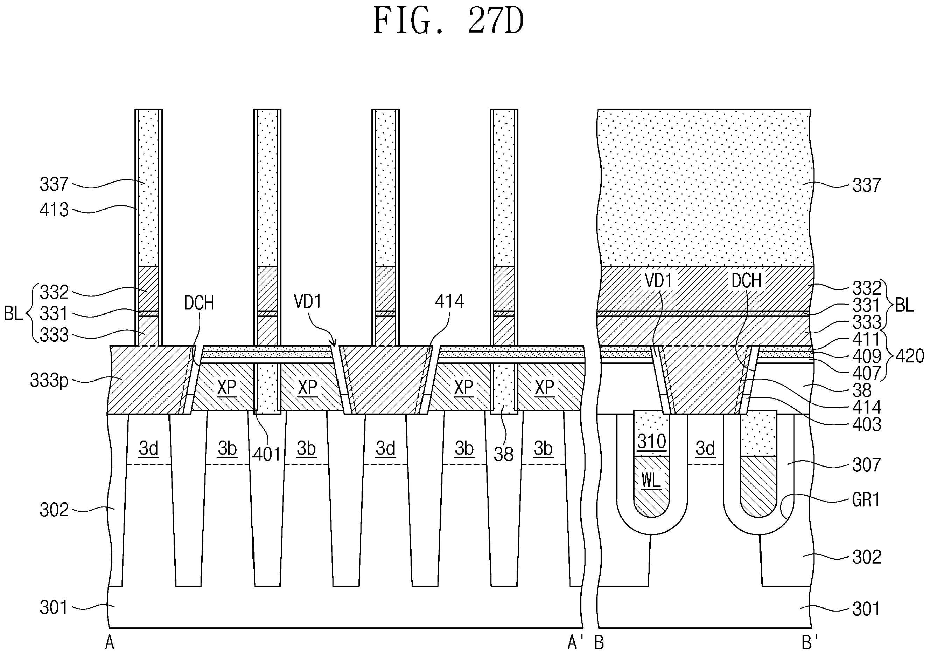

Referring to FIG. 27D, an impurity-doped polysilicon layer, a bit-line diffusion barrier layer, a bit-line wire layer, and a bit-line capping layer may be sequentially formed on the entire surface of the substrate 301. The polysilicon layer may fill the contact holes DCH. The bit-line capping layer, the bit-line wire layer, the bit-line diffusion barrier layer, and the polysilicon layer may be sequentially etched to expose a top surface of the interlayer insulator 420 and at the same time to form a bit-line capping pattern 337 and a bit line BL. The bit line BL may include a bit-line polysilicon pattern 333, a bit-line diffusion barrier pattern 331, and a bit-line wire pattern 332 that are sequentially stacked.

The bit line BL may be provided thereunder with a preliminary contact 333p that fills the contact hole DCH. The preliminary contact 333p and the lower protective spacer 414 may be formed of polysilicon, and thus no interface may be present between the preliminary contact 333p and the lower protective spacer 414. A first protective spacer 413 may be formed to cover a sidewall of the bit-line capping pattern 337 and a sidewall of the bit line BL.

The lower contact dielectric pattern 403 may be partially removed to form an empty space between the preliminary contact 333p and the storage node pad XP. The first protective spacer 413 may be removed. Subsequently, the processes discussed with reference to FIGS. 14A to 17B may be performed.

By way of summation and review, new exposure techniques or expensive exposure techniques may be used for fineness of the patterns, and it could be difficult to highly integrate semiconductor devices. New integration techniques may be considered.

According to an embodiment, a semiconductor memory device may improve in BBD and tRDL properties, and thus the semiconductor memory device may increase in speed and operate at lower powers. As a result, the semiconductor memory device may increase in reliability.

According to an embodiment, a method of fabricating a semiconductor memory device may prevent process defects and increase in yield.

One or more embodiments may provide a semiconductor memory device with increased reliability.

One or more embodiments may provide a method of fabricating a semiconductor memory device, which method is capable of reducing defects.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor memory device, comprising:
a first impurity region in a substrate;
a first bit line that crosses over the substrate and is connected to the first impurity region;
a bit-line contact between the first bit line and the first impurity region; and
a contact ohmic layer between the bit-line contact and the first impurity region,
wherein a width of a bottom surface of the bit-line contact is greater than a width of a bottom surface of the contact ohmic layer.

2. The device as claimed in claim 1, further comprising:
a second impurity region in the substrate, the second impurity region being spaced apart from the first impurity region; and
a storage node pad on the second impurity region,
wherein:
the storage node pad includes a pad silicon layer, a pad ohmic layer, and a pad metal layer that are sequentially stacked, and
a width of a bottom surface of the pad ohmic layer is less than a width of a bottom surface of the pad silicon layer and is greater than a width of a bottom surface of the pad metal layer.

3. The device as claimed in claim 2, further comprising a storage node contact on the pad metal layer, the storage node contact being in contact with the pad metal layer,
wherein:
the pad metal layer includes a first metal, and
the storage node contact includes a second metal.

4. The device as claimed in claim 1, further comprising:
a second impurity region in the substrate, the second impurity region being spaced apart from the first impurity region;
a storage node pad on the second impurity region;
a contact insulator between the storage node pad and a lower part of the bit-line contact;
a buried dielectric pattern between the storage node pad and an upper part of the bit-line contact; and
a first spacer between the buried dielectric pattern and the storage node pad and between the buried dielectric pattern and the bit-line contact,
wherein an outer sidewall of the first spacer is aligned with an outer sidewall of the contact insulator.

5. The device as claimed in claim 4, wherein:
the contact insulator surrounds the bit-line contact and extends beneath the first bit line, and
the contact insulator includes a first lower contact dielectric pattern and an upper contact dielectric pattern that are sequentially stacked.

6. The device as claimed in claim 5, wherein the contact insulator further includes a second lower contact dielectric pattern beneath the upper contact dielectric pattern, a sidewall and a bottom surface of the second lower contact dielectric pattern being covered with the first lower contact dielectric pattern.

7. The device as claimed in claim 6, wherein:
the contact insulator further includes a third lower contact dielectric pattern beneath the upper contact dielectric pattern and in contact with the second lower contact dielectric pattern,
the third lower contact dielectric pattern is spaced apart from the first lower contact dielectric pattern, and
a bottom end of the third lower contact dielectric pattern is higher than a bottom end of the second lower contact dielectric pattern.

8. The device as claimed in any of claims 4 to 7, wherein:
the storage node pad includes a pad silicon layer, a pad ohmic layer, and a pad metal layer that are sequentially stacked, and
a bottom end of the first spacer is higher than a top surface of the pad silicon layer.

9. The device as claimed in any preceding claim, wherein:
each of the bit-line contact and the contact ohmic layer includes a first metal, and
the first bit line includes a second metal.

10. The device as claimed in claim 1, further comprising:
a second impurity region and a third impurity region in the substrate and spaced apart from the first impurity region, the first impurity region, the second impurity region, and the third impurity region being linearly arranged in a first direction;
a first storage node pad on the second impurity region;
a second storage node pad on the third impurity region; and
a pad separation pattern between the first storage node pad and the second storage node pad,
wherein:
each of the first storage node pad and the second storage node pad includes a pad silicon layer, a pad ohmic layer, and a pad metal layer that are sequentially stacked, and
a bottom surface of the pad separation pattern is lower than a bottom surface of each pad silicon layer.

11. The device as claimed in claim 10, further comprising:
a second bit line on the pad separation pattern; and
an interlayer insulator between the second bit line and the pad separation pattern,
wherein:
the interlayer insulator includes a first interlayer dielectric layer, a second interlayer dielectric layer, and a third interlayer dielectric layer that are sequentially stacked, and
the second interlayer dielectric layer includes a material different from materials of the first interlayer dielectric layer and the third interlayer dielectric layer.

12. The device as claimed in claim 11, wherein:
sidewalls of the second interlayer dielectric layer and the third interlayer dielectric layer are aligned with a sidewall of the second bit line, and
a sidewall of the first interlayer dielectric layer is not aligned with the sidewall of the second bit line.

13. The device as claimed in any preceding claim, wherein:
the bit-line contact includes a lower part, an intermediate part, and an upper part when viewed from the substrate,
the upper part of the bit-line contact has a width that increases in a downward direction,
the intermediate part of the bit-line contact has a width that decreases in the downward direction, and
an edge of the lower part of the bit-line contact laterally protrudes from a sidewall of the intermediate part of the bit-line contact.

14. The device as claimed in any of claims 1 to 3 or 9 to 13, further comprising a contact insulator that surrounds the bit-line contact,
wherein a bottom end of the contact insulator is at a level the same as or higher than a level of the bottom surface of the contact ohmic layer.

15. The device as claimed in any preceding claim, wherein a lateral surface of a lower part of the bit-line contact is aligned with a lateral surface of the contact ohmic layer.
